# EUROPEAN PATENT SPECIFICATION

(11) **EP 1 112 314 B1**
(45) Date of publication and mention of the grant of the patent: **04.07.2007**
(21) Application number: 99938918.2
(22) Date of filing: 30.07.1999
(51) Int. Cl.: C08K 5/5399, C08L 69/00

(54) **FLAME RETARDANT RESIN COMPOSITIONS CONTAINING PHOSPHORAMIDES, AND METHOD FOR MAKING**
FLAMMHEMMENDE HARZZUSAMMENSETZUNG, ENTHALTEND PHOSPHORAMIDE UND HERSTELLUNGSMETHODE
COMPOSITIONS RESINEUSES IGNIFUGEANTES, CONTENANT DES PHOSPHORAMIDES, ET LEUR PROCEDE DE FABRICATION

(30) Priority: 31.08.1998 US 144687; 22.01.1999 US 235680; 08.07.1999 US 404459
(43) Date of publication of application: 04.07.2001
(73) Proprietor: GENERAL ELECTRIC COMPANY, Schenectady, NY 12345 (US)
(72) Inventor: CAMPBELL, John, Robert, Clifton Park, NY 12065 (US); FALCONE, Neal, Steven, Uncasville, CT 06382 (US); GOOSSENS, Johanes, Martinus, Din, NL-Bergen op Zoom (NL); GOVAERTS, Luc, Carlos, B-2320 Hoogstraten (BE); VERHOOGT, Hendrik, NL-Bergen op Zoom (NL); LUCAS, Richard, NL-4617 Bergen op Zoom (NL)
(74) Representative: Szary, Anne Catherine
(86) International application number: PCT/US1999/017371
(87) International publication number: WO 2000/012614

(56) References cited:
- EP-A- 0 171 730
- WO-A-93/22373
- DE-A- 1 694 354
- PATENT ABSTRACTS OF JAPAN vol. 005, no. 008 (C-039), 20 January 1981 (1981-01-20) & JP 55 135158 A (ASAHI CHEM IND CO LTD), 21 October 1980 (1980-10-21)
- PATENT ABSTRACTS OF JAPAN vol. 1998, no. 11, 30 September 1998 (1998-09-30) & JP 10 175985 A (TOSOH CORP), 30 June 1998 (1998-06-30)

## Description

This application is a continuation-in-part of copending application Serial No. 09/235,680, filed January 22, 1999.

### BACKGROUND OF THE INVENTION

The present invention relates to resin compositions comprising a phosphoramide compound having a glass transition temperature of at least about 0°C, preferably of at least about 10°C, and most preferably of at least about 20°C. The invention also relates to methods to make the resin compositions and articles made from the resin compositions.

Compounds containing phosphorus have been used in resin compositions for a variety of reasons. For example, various phosphites have been utilized to enhance the melt stability and/or color stability of resin compositions. Alternatively, various organic phosphate esters have been utilized in resin compositions to improve the flame resistance properties of the compositions and/or to enhance the melt flow characteristics of the compositions. Certain water soluble phosphoramides have also been used in the textile industry as flame retardant finishes for fabrics.

As part consolidation and weight reduction continues to evolve in many industries, the physical property demands placed upon resin manufacturers are increasing. Key industries increasing the demands include the electronics and computer industries, especially for computer housings, computer monitor housings, and printer housings. One increasing demand is for materials that possess higher heat resistance while preferably substantially retaining other key physical properties. Another increasing demand is for materials that are rated in the Underwriter's Laboratory UL-94 test protocol as V-0, V-1, or V-2. It is therefore apparent that new resin compositions that meet these and other demands continue to be sought.

WO-A-9322373 discloses a flame-retardant additive comprising a source of phosphorus and a polymer or oligomer which is a phosphorus/nitrogen-containing oligomer or polymer. These additives are found to be particularly suitable for use in polymer materials when used in combination with a second and different source of phosphorus, resulting in an additive having reduced smoke generation, reduced evolution of corrosive gases and improved flame-retarding properties.

JP-A-10175985 discloses a nitrogen-containing organic phosphoric acid compounding not containing any halogen atom and having excellent flame retardance, heat resistance water resistance, an improved micscibility with a resin and suitable as a flame-retardant agent. The compound may be obtained by reacting 1mol of piperazine with 2mol of diphenyl phosphoryl chlorides in the presence of an amine catalyst.

### SUMMARY OF THE INVENTION

The present invention provides flame retardant resin compositions comprising the following and any reaction products thereof :
a) a thermoplastic resin;
b) at least one phosphoramide having a glass transition point of at least about 0°C, preferably of at least about 10°C, and most preferably of at least about 20°C, of the formula: 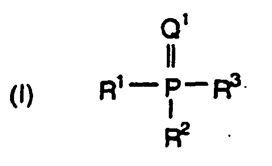 wherein Q1 is oxygen or sulfur; R1 is an amine residue, and R2 and R3 are each independently an alkyloxy, alkylthio, aryloxy, or arylthio residue, or an aryloxy or arylthio residue containing at least one alkyl substitution; or an amine residue; and
c) at least one adjunct flame retardant compound, wherein the thermoplastic resin and the adjunct flame retardant compound are as defined in claim 1.

The present invention also provides articles made from the resin compositions. Furthermore, the present invention provides methods to make resin compositions having improved heat and/or processability over compositions known in the art.

### DETAILED DESCRIPTION OF THE INVENTION

Polycarbonates useful in the compositions of the invention include those comprising structural units of the formula IV: 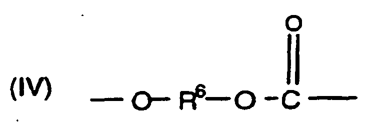 wherein at least about 60 percent of the total number of R6 groups are aromatic organic radicals and the balance thereof are aliphatic, alicyclic, or aromatic radicals. More preferably, R6 is an aromatic organic radical and still more preferably a radical of the formula V:

(V) -A¹-Y¹-A²-.

wherein each A1 and A2 is a monocyclic divalent aryl radical and Y1 is a bridging radical in which one or two atoms, separate A1 from A2. The preferred embodiment is one in which one atom separates A1 from A2. Illustrative non-limiting examples of radicals of this type are -O-, -S-, -S(O)- or -S(O2)-, -C(O)-, methylene, cyclohexyl-methylene, 2-[2.2.1]-bicycloheptylidene, ethylidene, isopropylidene, neopentylidene, cyclohexylidene, 3,3,5-trimethylcyclohexylidene, cyclopentadecylidene, cyclododecylidene, and adamantylidene. The bridging radical Y1 is most often a hydrocarbon group and particularly a saturated group such as methylene, cyclohexylidene, 3,3,5-trimethylcyclohexylidene, or isopropylidene.

Preferred polycarbonates are derived from dihydric phenols in which only one atom separates A1 and A2. Some illustrative, non-limiting examples of dihydric phenols include the dihydroxy-substituted aromatic hydrocarbons disclosed by name or formula (generic or specific) in U.S. Patent 4,217,438, which is incorporated herein by reference. Some preferred examples of dihydric phenols include 2,2-bis(4-hydroxyphenyl)propane (commonly known as bisphenol A); 4,4'-(3,3,5-trimethylcydohexylidene)diphenol; 2,2-bis(4-hydroxy-3,5-dimethylphenyl)propane; 2,4'-dihyroxydiphenylmethane; bis(2-hydroxyphenyl)methane; bis(4-hydroxyphenyl)methane; bis(4-hydroxy-5-nitrophenyl)methane; bis(4-hydroxy-2,6-dimethyl-3-methoxyphenyl)methane; 1,1-bis(4-hydroxyphenyl)ethane; 1,1-bis(4-hydroxy-2-chlorophenyl)ethane; 2,2-bis(3-phenyl-4-hydroxyphenyl)-propane; bis(4-hydroxyphenyl)-cyclohexylmethane; 2,2-bis(4-hydroxyphenyl) -1-phenylpropane; resorcinol; C1-3 alkyl-substituted resorcinols, and 6,6'-dihydroxy- 3,3,3',3'-tetramethyl-1,1'-spirobiindane.

The most preferred polycarbonates are bisphenol A polycarbonates, in which each of A1 and A2 is p-phenylene and Y1 is isopropylidene. Preferably, the weight average molecular weight of the initial polycarbonate ranges from about 5,000 to about 100,000; more preferably from about 10,000 to about 65,000, still more preferably from about 16,000 to about 40,000, and most preferably from about 20,000 to about 36,000. Suitable polycarbonates may be made using any process known in the art, including interfacial, solution, solid-state, or melt processes.

In one embodiment the present invention comprises a composition containing at least one polycarbonate. In another embodiment the invention comprises compositions containing two different polycarbonates. Both homopolycarbonates derived from a single dihydroxy compound monomer and copolycarbonates derived from more than one dihydroxy compound monomer are encompassed. In a preferred embodiment compositions comprise a bisphenol A homopolycarbonate and a copolycarbonate comprising bisphenol A monomer units and 4,4'-(3,3,5-trimethylcyclohexylidene)diphenol monomer units. Preferably, the copolycarbonate comprises 5-65 mole %, more preferably 15-60 mole %, and most preferably 30-55 mole % of 4,4'(3,3,5-trimethylcyclohexylidene)diphenol with the remaining dihydroxy monomer being bisphenol A. The weight ratio of bisphenol A polycarbonate to copolycarbonate comprising bisphenol A monomer units and 4,4'-(3,3,5-trimethylcyclohexylidene)diphenol monomer units in compositions of the present invention is preferably between 95:5 and 70:30 and more preferably between 85:15 and 75:25.

Also suitable for use in the present invention are polyestercarbonates. The polyestercarbonates may generally be termed copolyesters containing carbonate groups, carboxylate groups, and aromatic carbocyclic groups in the polymer chain, in which at least some of the carboxylate groups and at least some of the carbonate groups are bonded directly to ring carbon atoms of the aromatic carbocyclic groups. These polyestercarbonates are, in general, prepared by reacting at least dihydric phenol, at least one difunctional carboxylic acid or reactive derivative of the acid such as the acid dihalide, and a carbonate precursor. Suitable dihydric phenols include, but are not limited to, those named or referred to hereinabove. Some illustrative, non-limiting examples of suitable aromatic dicarboxylic acids include phthalic acid, isophthalic acid, terephthalic acid, homophthalic acid, o-, m-, and p-phenylenediacetic acid; and the polynuclear aromatic acids such as diphenic acid, 1,4-naphthalene dicarboxylic acid, 2,6-naphthalene dicarboxylic acid, and the like. These acids may be used either individually, or as a mixture of two or more different acids in the preparation of suitable polyestercarbonates.

The polyestercarbonates which find use in the instant invention and the methods for their preparation are well known in the art as disclosed in, for example, U.S. Pat. Nos. 3,030,331; 3,169,121; 3,207,814; 4,194,038; 4,156,069; 4,238,596; 4,238,597; 4,487,896; 4,506,065, and in copending application Ser. No. 09/181,902, filed Oct. 29, 1998, and assigned to the same assignee as the instant application, all of which are hereby incorporated by reference. Among the properties characterizing these polymers is a relatively high distortion temperature under load (DTUL) as well as a relatively high impact strength as measured by a notched Izod test protocol.

The polyarylene ethers are most often polyphenylene ethers having structural units of the formula: 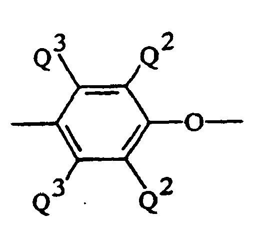 wherein each Q2 is independently halogen, primary or secondary lower alkyl, phenyl, haloalkyl, aminoalkyl, hydrocarbonoxy, or halohydrocarbonoxy wherein at least two carbon atoms separate the halogen and oxygen atoms, and each Q3 is independently hydrogen, halogen, primary or secondary lower alkyl, phenyl, haloalkyl, hydrocarbonoxy or halohydrocarbonoxy as defined for Q2.

Both homopolymer and copolymer polyphenylene ethers are included. The preferred homopolymers are those containing 2,6-dimethyl-1,4-phenylene ether units. Suitable copolymers include random copolymers containing such units in combination with, for example, 2,3,6-trimethyl-1,4-phenylene ether units. Also included are polyphenylene ethers containing moieties prepared by grafting onto the polyphenylene ether in known manner such materials as vinyl monomers or polymers such as polystyrenes and elastomers, as well as coupled polyphenylene ethers in which coupling agents such as low molecular weight polycarbonates, quinones, heterocycles and formals undergo reaction in known manner with the hydroxy groups of two polyphenylene ether chains to produce a higher molecular weight polymer.

The polyphenylene ethers generally have an intrinsic viscosity greater than about 0.1, most often in the range of about 0.2-0.6 and especially about 0.35-0.6 deciliters per gram (dl./g.), as measured in chloroform at 25°C.

The polyphenylene ethers are typically prepared by the oxidative coupling of at least one monohydroxyaromatic compound such as 2,6-xylenol or 2,3,6-trimethylphenol. Catalyst systems are generally employed for such coupling; they typically contain at least one heavy metal compound such as a copper, manganese or cobalt compound, usually in combination with various other materials.

Particularly useful polyphenylene ethers for many purposes are those which comprise molecules having at least one aminoalkyl-containing end group. The aminoalkyl radical is covalently bound to a carbon atom located in an ortho position to a hydroxy group. Products containing such end groups may be obtained by incorporating an appropriate primary or secondary monoamine such as di-n-butylamine or dimethylamine as one of the constituents of the oxidative coupling reaction mixture. Also frequently present are 4-hydroxybiphenyl end groups and/or biphenyl structural units, typically obtained from reaction mixtures in which a by-product diphenoquinone is present, especially in a copper-halide-secondary or tertiary amine system. A substantial proportion of the polymer molecules, typically constituting as much as about 90% by weight of the polymer, may contain at least one of said aminoalkyl-containing and 4-hydroxy-biphenyl end groups. It will be apparent to those skilled in the art from the foregoing that the polyphenylene ethers contemplated for use in the invention include all those presently known, irrespective of variations in structural units or ancillary chemical features.

Both homopolymer and copolymer thermoplastic polymers are included in the compositions of the present invention. Copolymers may include random, block or graft type. Thus, for example, suitable polystyrenes include homopolymers, such as amorphous polystyrene and syndiotactic polystyrene, and copolymers. The latter embraces high impact polystyrene (HIPS), a genus of rubber-modified polystyrenes comprising blends and grafts wherein the rubber is a polybutadiene or a rubbery copolymer of about 70-98% styrene and 2-30% diene monomer. Also included are ABS copolymers, which are typically grafts of styrene and acrylonitrile on a previously formed diene polymer backbone (e.g., polybutadiene or polyisoprene). Suitable ABS copolymers may be produced by any methods known in the art. Especially preferred ABS copolymers are typically produced by mass polymerization (often referred to as bulk ABS) or emulsion polymerization (often referred to as high rubber graft ABS).

The preferred thermoplastic polymers for many purposes are polycarbonates, polyphenylene ethers, polystyrene resin, high impact polystyrene resin (HIPS), and styrene-acrylonitrile copolymers (SAN), including ABS copolymers. These may be employed individually or as blends. Especially preferred blends include those of polyphenylene ether with at least one of HIPS, amorphous polystyrene, and syndiotactic polystyrene; and polycarbonate blends with at least one of ABS, SAN, and polyester.

In resinous compositions there is often an improvement in melt flow and /or other physical properties when one molecular weight grade of at least one resinous constituent is combined with a relatively lower molecular weight grade of similar resinous constituent. Illustrative, non-limiting examples include compositions containing polycarbonate, polyphenylene ether, thermoplastic polyester, thermoplastic elastomeric polyester, or polyamide. For example, in a polycarbonate-containing blend there is often an improvement in melt flow when one molecular weight grade of polycarbonate is combined with a proportion of a relatively lower molecular weight grade of similar polycarbonate. Therefore, the present invention encompasses compositions comprising only one molecular weight grade of a particular resinous constituent and also compositions comprising two or more molecular weight grades of similar resinous constituent. When two or more molecular weight grades of similar resinous constituent are present, then the weight average molecular weight of the lowest molecular weight constituent is about 10% to about 95%, preferably about 40% to about 85%, and more preferably about 60% to about 80% of the weight average molecular weight of the highest molecular weight constituent. In one representative, non-limiting embodiment polycarbonate-containing blends include those comprising a polycarbonate with weight average molecular weight between about 28,000 and about 32,000 combined with a polycarbonate with weight average molecular weight between about 16,000 and about 26,000. When two or more molecular weight grades of similar resinous constituent are present, the weight ratios of the various molecular weight grades may range from about 1 to about 99 parts of one molecular weight grade and from about 99 to about 1 parts of any other molecular weight grades. A mixture of two molecular weight grades of a resinous constituent is often preferred, in which case the weight ratios of the two grades may range from about 99:1 to about 1:99, preferably from about 80:20 to about 20:80, and more preferably from about 70:30 to about 50:50. Since not all manufacturing processes for making a particular resinous constituent are capable of making all molecular weight grades of that constituent, the present invention encompasses compositions comprising two or more molecular weight grades of similar resinous constituent in which each of the similar resins is made by a different manufacturing process. In one particular embodiment the instant invention encompasses compositions comprising a polycarbonate made by an interfacial process in combination with a polycarbonate of different weight average molecular weight made by a melt process.

Another constituent of the resin compositions of the invention is at least one phosphoramide having a glass transition point of at least about 0°C, preferably of at least about 10°C, and most preferably of at least about 20°C, of the formula I: 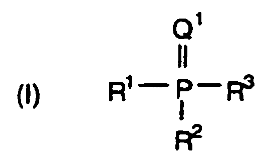 wherein Q1 is oxygen or sulfur; R1 is an amine residue, and R2 and R3 are each independently an alkyloxy, alkylthio, aryloxy, or arylthio residue, or an aryloxy or arylthio residue containing at least one alkyl or halogen substitution, or mixture thereof; or an amine residue.

It should be noted that in the descriptions herein, the words "radical" and "residue" are used interchangeably, and are both intended to designate an organic moiety. For example, alkyl radical and alkyl residue are both intended to designate an alkyl moiety. The term "alkyl" as used in the various embodiments of the present invention is intended to designate both normal alkyl, branched alkyl, aralkyl, and cycloalkyl radicals. Normal and branched alkyl radicals are preferably those containing from 1 to about 12 carbon atoms, and include as illustrative non-limiting examples methyl, ethyl, propyl, isopropyl, butyl, tertiary-butyl, pentyl, neopentyl, and hexyl. Cycloalkyl radicals represented are preferably those containing from 3 to about 12 ring carbon atoms. Some illustrative non-limiting examples of these cycloalkyl radicals include cyclobutyl, cyclopentyl, cyclohexyl, methylcyclohexyl, and cycloheptyl. Preferred aralkyl radicals are those containing from 7 to about 14 carbon atoms; these include, but are not limited to, benzyl, phenylbutyl, phenylpropyl, and phenylethyl. Aryl radicals used in the various embodiments of the present invention are preferably those containing from 6 to 12 ring carbon atoms. Some illustrative non-limiting examples of these aryl radicals include phenyl, biphenyl, and naphthyl. The preferred halogen radicals used in the various embodiments of the present invention are chlorine and bromine.

The compositions may contain essentially a single phosphoramide or a mixture of two or more different types of phosphoramides. Compositions containing essentially a single phosphoramide are preferred.

When a phosphoramide having a glass transition point of at least about 0°C is used as a source of phosphorus in resin compositions, it was unexpectedly found that a higher heat deflection temperature of test specimens made from the resin composition could be obtained as compared to compositions containing an organophosphate known in the art for enhancing the processability and/or flame resistance characteristics of the composition.

Although the invention is not dependent upon mechanism, it is believed that selection of each of R1, R2, and R3 residues that result in restricted rotation of the bonds connected to the phosphorus provide an increased glass transition point in comparison to similar phosphoramides with residues having a lesser degree of restriction. Residues having bulky substituents such as, for example, aryloxy residues containing at least one halogen, or preferably at least one alkyl substitution, result in phosphoramides having a higher glass transition point than similar phosphoramides without the substitution on the aryloxy residue. Likewise, residues wherein at least two of the R1, R2, and R3 residues are interconnected, such as a neopentyl residue for the combination of the R2 and R3 residues, can lead to desired phosphoramides having a glass transition point of at least about 0°C.

In a preferred embodiment, the phosphoramide comprises a phosphoramide having a glass transition temperature of at least about 0°C, preferably of at least about 10°C, and most preferably of at least about 20°C, of the formula VI: 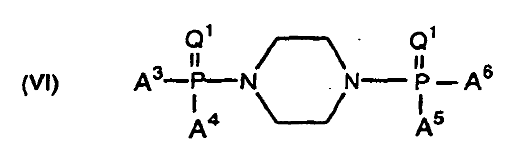 wherein each Q1 is independently oxygen or sulfur; and each of A3-6 is independently an alkyloxy, alkylthio, aryloxy, or arylthio residue, or an aryloxy or arylthio residue containing at least one alkyl or halogen substitution, or mixture thereof; or an amine residue. In an especially preferred embodiment of the invention, each Q1 is oxygen, and each A3-6 moiety is a 2,6-dimethylphenoxy moiety or a 2,4,6-trimethyl-phenoxy moiety. These phosphoramides are piperazine-type phosphoramides. In the above formula wherein each Q1 is oxygen, and each A3-6 moiety is a 2,6-dimethylphenoxy moiety, the glass transition temperature of the phosphoramide is about 62°C and the melting point is about 192°C. Conversely, in the above formula wherein each Q1 is oxygen, and each A3-6 moiety is phenoxy, the glass transition temperature of the phosphoramide is about 0°C and the melting point is about 188°C. It was unexpected that the glass transition temperature would be so high (i.e. about 62°C) for the phosphoramide of formula VI where each Q1 is oxygen, and wherein each of A3-6 is a 2,6-dimethylphenoxy moiety as compared to the corresponding phosphoramide of formula VI wherein each Q1 is oxygen, and each of A3-6 is a phenoxy moiety (i.e. about 0°C), especially since the melting points for the phosphoramides differ by only about 4°C. For comparison, the glass transition temperature of tetraphenyl resorcinol diphosphate is about -38°C. It is also possible to make phosphoramides with intermediate glass transition temperatures by using a mixture of various substituted and non-substituted aryl moieties within the phosphoramide.

In another preferred embodiment, the phosphoramide comprises a phosphoramide having a glass transition temperature of at least about 0°C, preferably of at least about 10°C, and most preferably of at least about 20°C, of the formula VII: 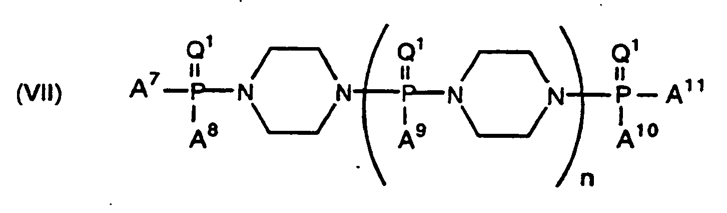 wherein each Q1 is independently oxygen or sulfur; and each of A7-11 is independently an alkyloxy, alkylthio, aryloxy, or arylthio residue, or an aryloxy or arylthio residue containing at least one alkyl or halogen substitution, or mixture thereof; or an amine residue; and n is from 0 to about 5. In a more preferred embodiment, each Q1 is oxygen, and each A7-11 moiety is independently phenoxy, 2,6-dimethylphenoxy, or 2,4,6-trimethylphenoxy, and n is from 0 to about 5.

In another embodiment of the invention the phosphoramide comprises a phosphoramide having a glass transition temperature of at least about 0°C, preferably of at least about 10°C, and most preferably of at least about 20°C, of the formula VIII : 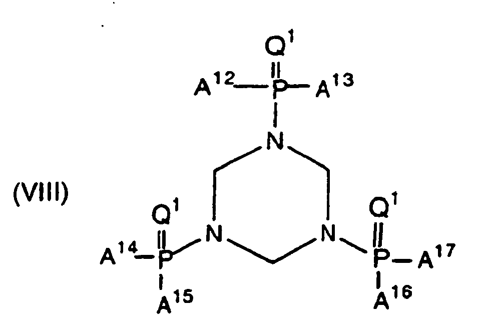 wherein each Q1 is independently oxygen or sulfur; and each of A12-17 is independently an alkyloxy, alkylthio, aryloxy, or arylthio residue, or an aryloxy or arylthio residue containing at least one alkyl or halogen substitution, or mixture thereof; or an amine residue. In a more preferred embodiment, each Q1 is oxygen, and each A12-17 moiety is independently phenoxy, 2,6-dimethylphenoxy, or 2,4,6-trimethyl-phenoxy.

In another embodiment of the invention the phosphoramide comprises a phosphoramide having a glass transition temperature of at least about 0°C, preferably of at least about 10°C, and most preferably of at least about 20°C, of the formula IX: 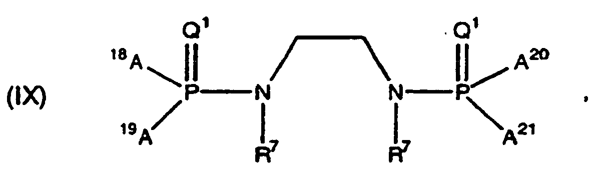 wherein each Q1 is independently oxygen or sulfur; each of A18-21 is independently an alkyloxy, alkylthio, aryloxy, or arylthio residue, or an aryloxy or arylthio residue containing at least one alkyl or halogen substitution, or mixture thereof; or an amine residue; and each R7 is an alkyl radical, or both R7 radicals taken together are an alkylidene or alkyl-substituted alkylidene radical. In a preferred embodiment, each Q1 is oxygen; both R7 radicals taken together are an unsubstituted (CH2)m alkylidene radical, wherein m is 2 to 10; and each A18-21 moiety is independently phenoxy, 2,6-dimethylphenoxy, or 2,4,6-trimethylphenoxy. In a more preferred embodiment, each Q1 is oxygen; each R7 is methyl; and each A18-21 moiety is independently phenoxy, 2,6-dimethylphenoxy, or 2,4,6-trimethylphenoxy.

In another embodiment of the invention, the phosphoramide comprises a phosphoramide having a glass transition point of at least about 0°C, preferably of at least about 10°C, and most preferably of at least about 20°C, of the formula I: 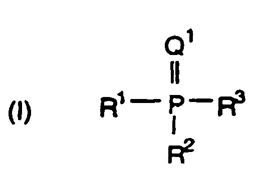 wherein Q1 is oxygen or sulfur, and R1 is of the formula X: 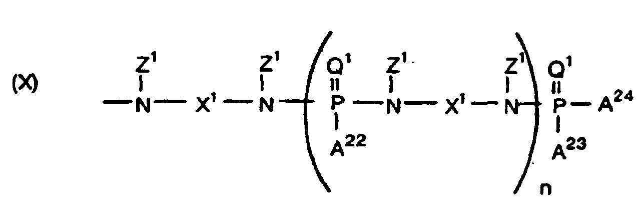 wherein each Q1 is independently oxygen or sulfur; each of A22-24 is independently an alkyloxy, alkylthio, aryloxy, or arylthio residue, or an aryloxy or arylthio residue containing at least one alkyl or halogen substitution, or mixture thereof; or an amine residue; each Z1 is an alkyl radical, aromatic radical, or aromatic radical containing at least one alkyl or halogen substitution or mixture thereof; each X1 is an alkylidene radical, aromatic radical, or aromatic radical containing at least one alkyl or halogen substitution or mixture thereof; n is from 0 to about 5; and R2 and R3 are each independently an alkyloxy, alkylthio, aryloxy, or arylthio residue, or an aryloxy or arylthio residue containing at least one alkyl or halogen substitution, or mixture thereof; or an amine residue. In a preferred embodiment, each Q1 is oxygen; each A22-24 moiety is independently phenoxy, 2,6-dimethylphenoxy, or 2,4,6-trimethylphenoxy; each Z1 is methyl or benzyl; each X1 is an alkylidene radical containing 2-24 carbon atoms; n is from 0 to about 5; and R2 and R3 are each independently phenoxy, 2,6-dimethylphenoxy, or 2,4,6-trimethylphenoxy.

In another embodiment of the invention, the phosphoramide comprises a phosphoramide having a glass transition point of at least about 0°C, preferably of at least about 10°C, and most preferably of at least about 20°C, of the formula I: 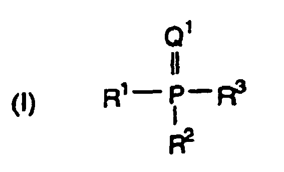 wherein Q1 is oxygen or sulfur; and R1 is of the formula XI: 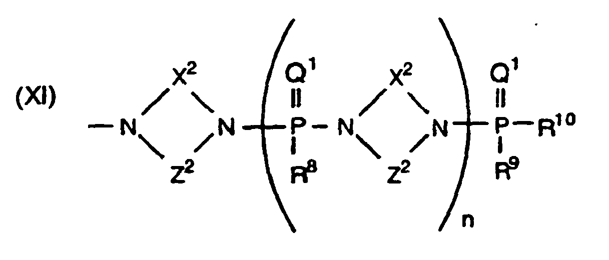 wherein each Q1 is independently oxygen or sulfur; each X2 is an alkylidene or alkyl-substituted alkylidene residue, aryl residue, or alkaryl residue; each Z2 is an alkylidene or alkyl-substituted alkylidene residue; each of R8, R9, and R10 is independently an alkyloxy, alkylthio, aryloxy, or arylthio residue, or an aryloxy or arylthio residue containing at least one alkyl or halogen substitution, or mixture thereof; or an amine residue; n is from 0 to about 5; and R2 and R3 are each independently an alkyloxy, alkylthio, aryloxy, or arylthio residue, or an aryloxy or arylthio residue containing at least one alkyl or halogen substitution, or mixture thereof; or an amine residue. In a preferred embodiment, each Q1 is oxygen; each X2 is an alkylidene or alkyl-substituted alkylidene residue; each Z2 is an alkylidene or alkyl-substituted alkylidene residue; each of R2, R3, R8, R9, and R10 is independently phenoxy, 2,6-dimethylphenoxy, or 2,4,6-trimethylphenoxy; and n is from 0 to about 5. In a more preferred embodiment, each Q1 is oxygen; each X2 and Z2 is independently an unsubstituted alkylidene residue of the form (CH2)m, wherein m is 2 to 10; each of R2, R3, R8, R9, and R10 is independently phenoxy, 2,6-dimethylphenoxy, or 2,4,6-trimethyl-phenoxy; and n is from 0 to about 5. In an especially preferred embodiment, the phosphoramide is derived from piperazine (i.e. X2 and Z2 are each -CH2-CH2-).

In another preferred embodiment, the phosphoramide comprises a cyclic phosphoramide having a glass transition point of at least about 0°C, preferably of at least about 10°C, and most preferably of at least about 20°C of the formula XII : 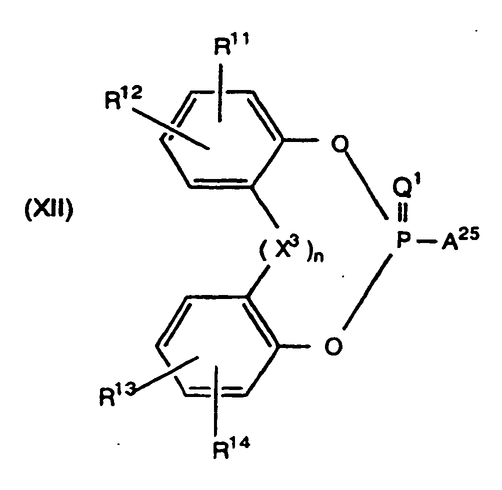 wherein each of R11-14 is independently a hydrogen or an alkyl radical, X3 is an alkylidene radical, Q1 is oxygen or sulfur, and A25 is a group derived from a primary or secondary amine having the same or different radicals that can be aliphatic, alicyclic, aromatic, or alkaryl, or A25 is a group derived from a heterocyclic amine, or A25 is a hydrazine compound. Preferably Q1 is oxygen. It should be noted that when n is 0, then the two aryl rings are linked together at that site (i.e. where X3 is absent) by a single bond in the positions ortho,ortho' to the phosphoryl bonds.

In another preferred embodiment, the phosphoramide comprises a bis(cyclic) phosphoramide having a glass transition point of at least about 0°C, preferably of at least about 10°C, and most preferably of at least about 20°C of the formula XIII: 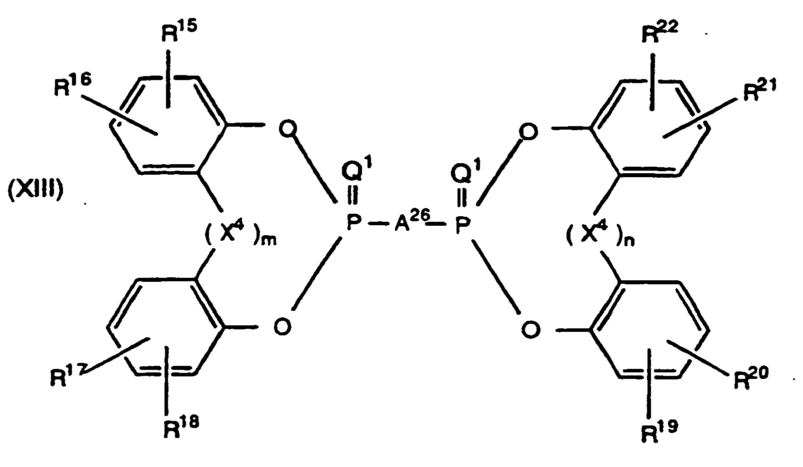 wherein Q1 is oxygen or sulfur; each of R15-22 is independently a hydrogen or an alkyl radical; X4 is an alkylidene radical; m and n are each independently 0 or 1; and A26 is 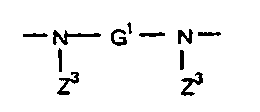 wherein G1 is sulfur, an alkylidene radical, alkyl-substituted alkylidene radical, aryl radical, or alkaryl radical, and each Z3 is independently an alkyl radical, an aryl radical, or an aryl radical containing at least one alkyl or halogen substitution, or mixture thereof; or wherein A26 is 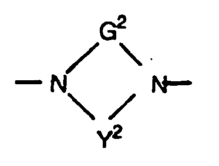 wherein G2 is alkylidene, aryl, or alkaryl, and Y2 is alkylidene or alkyl-substituted alkylidene. Preferred phosphoramides are those wherein Q1 is oxygen, A26 is a residue of piperazine, and the phosphoramide has a plane of symmetry through A26. Highly preferred phosphoramides include those
wherein Q1 is oxygen; A26 is a residue of piperazine; the phosphoramide has a plane of symmetry through A26; at least one R substituent on each aryl ring is a methyl adjacent to the oxygen substituent; n and m are each 1; and X4 is CHR23 wherein R23 is a hydrogen or an alkyl residue of from about 1 to about 6 carbon atoms. It should be noted that when either or both of m or n is 0, then the two aryl rings are linked together at that site (i.e. where X4 is absent) by a single bond in the positions ortho,ortho' to the phosphoryl bonds.

Phosphoramides of useful molecular structure are preferably prepared by the reaction of a corresponding amine such as, for example, piperazine or N,N'-dimethylethylenediamine with a diaryl chlorophosphate of the formula (aryl-O)2POCl in the presence of a tertiary amine. This method of preparation is described in Talley, J. Chem. Eng. Data, 33, 221-222 (1988) and leads to specific phosphoramide compounds without repeating units. Alternatively, phosphoramides may be prepared by the reaction of the corresponding amine with P(O)Cl3 in the presence of a tertiary amine, with the desired hydroxyl- or thiohydroxy-containing compound added simultaneously or subsequently to the addition of the amine. Addition of a diamine or triamine to P(O)Cl₃ with simultaneous or subsequent addition of the hydroxyl or thiohydroxy-containing compound is believed to lead to repeating units of phosphoramide, often of 1 to about 5 phosphoramide linkages per compound. Similarly, addition of a diamine or triamine to a monosubstituted phosphoryl- or thiophosphoryl dichloride with simultaneous or subsequent addition of hydroxyl- or thiohydroxy-containing compound is also believed to lead to repeating units of phosphoramide. P(S)C13 may be substituted for P(O)C13 in the above preparations to provide suitable phosphoramides.

Another constituent of the resin compositions of the invention is at least one adjunct flame retardant compound. An adjunct flame retardant compound may be an organic or inorganic, polymeric or non-polymeric compound. In certain preferred embodiments an adjunct flame retardant is one which may promote char formation in at least one resinous constituent, for example in polycarbonate when polycarbonate is a blend constituent.

In one embodiment of the present invention the adjunct flame retardant comprises at least one polymeric or non-polymeric organic phosphorus species selected from the group consisting of phosphate esters, thiophosphate esters, phosphonate esters, thiophosphonate esters, phosphinate esters, thiophosphinate esters, phosphines, including triphenylphosphine, phosphine oxides, including triphenylphosphine oxide and tris(2-cyanoethyl)phosphine oxide, thiophosphine oxides, and phosphonium salts. Preferred organic phosphorus species are non-polymeric phosphate esters including, for example, alkyl phosphate esters, aryl phosphate esters, resorcinol-based phosphate esters, and bisphenol-based phosphate esters. Illustrative, non-limiting examples of such phosphorus species include triphenylphosphate, tricresylphosphate, resorcinol bis(diphenyl-phosphate), bisphenol A bis(diphenyl-phosphate), and other aromatic phosphate esters known in the art.

In one embodiment of the invention the combination of adjunct flame retardant and at least one phosphoramide having a glass transition point of at least about 0°C results in a flame retardant composition having a UL-94 rating of V-2, V-1, or V-0. In another embodiment of the invention the presence of certain amounts of adjunct flame retardant permits the use of a lesser amount of at least one phosphoramide having a glass transition point of at least about 0°C without substantial loss in flame retardant properties of the composition. Without substantial loss in flame retardant properties of the composition means that the UL-94 rating for the composition does not become worse in the presence of phosphoramide/adjunct flame retardant combination compared to that rating observed in the absence of adjunct flame retardant. A UL-94 rating becomes worse, for example, when it increases from V-0 to either V-1 or V-2, or when it increases from V-1 to V-2. In yet another embodiment of the invention the flame retardant properties of the composition become better in the presence of phosphoramide/adjunct flame retardant combination compared to those observed in the absence of adjunct flame retardant. Better flame retardant properties mean that either the flame out time (defined hereinafter below) for the composition decreases and/or that the UL-94 rating for the composition improves, for example, from V-2 to either V-1 or V-0, or from V-1 to V-0. In still another embodiment of the invention a synergistic effect on composition properties, particularly flame retardant properties, is observed in the presence of the phosphoramide/adjunct flame retardant combination compared to that observed in the presence of at least one phosphoramide or adjunct flame retardant alone.

The resinous compositions of this invention may contain a flame retarding amount and/or processability enhancing amount of the combination of at least one phosphoramide and adjunct flame retardant. Flame retardancy is preferably measured according to the Underwriters' Laboratory UL-94 protocol. A flame retarding amount is an amount effective to render the composition at least a V-2 rating, preferably at least a V-1 rating, and most preferably a V-0 rating after testing in the UL-94 protocol when measured on a test specimen of about 0.03 to about 0.125 inch in thickness by about 0.5 inch by about 5 inch, preferably about 0.125 inch in thickness by about 0.5 inch by about 5 inch, more preferably about 0.06 inch in thickness by about 0.5 inch by about 5 inch, and most preferably about 0.03 inch in thickness by about 0.5 inch by about 5 inch dimensions. Enhanced processability can be determined, for example, as a reduction in extruder torque during compounding, reduced pressure in injection molding, reduced viscosity, and/or decreased cycle time.

Typically, a flame retarding amount of the combination of at least one phosphoramide and at least one adjunct flame retardant in the compositions of the invention is in the range of about 0.008-5 parts, preferably about 0.1-25 parts, of phosphorus per 100 parts of resinous materials (phr), all percentages herein being by weight. The total amount of phosphoramide and adjunct flame retardant is most often in the range of about 0.1-50 phr, preferably about 0.5-35 phr, and more preferably about 1-25 phr.

In one embodiment of the present invention halogen-containing flame retardants or other halogen-containing species may also be present in the compositions as adjunct flame retardants. In many resinous compositions, the combination of a halogen-containing flame retardant and at least one phosphoramide (or mixture of phosphoramide with another adjunct flame retardant), particularly including a phosphoramide having a glass transition point of at least about 0°C, provides both suitable flame retardant properties and unexpectedly improved high temperature properties (such as measured, for example, by HDT or Tg of a resinous phase). Illustrative, non-limiting examples of halogen-containing flame retardants or halogen-containing species include brominated flame retardants and phosphoramides containing halogenated aromatic substituents. Due to environmental regulations chlorine-free and bromine-free compositions may be preferred for certain applications. Therefore, in a preferred embodiment the present invention includes compositions comprising a thermoplastic resin, at least one phosphoramide having a glass transition point of at least about 0°C, and an adjunct flame retardant, said compositions being essentially free of chlorine and bromine. In this context essentially free means that no chlorine- or bromine-containing species has been added to the compositions in their formulation. In another of its embodiments the present invention includes articles obtained from said chlorine-free or bromine-free compositions.

The compositions of the invention may also contain other conventional additives including stabilizers, inhibitors, plasticizers, fillers, mold release agents, and anti-drip agents. Anti-drip agents are illustrated by tetrafluoroethylene polymers or copolymers, including mixtures with such other polymers as polystyrene-co-acrylonitrile (sometimes referred to herein as styrene-acrylonitrile copolymer).

A principal characteristic of preferred compositions of the invention is their improved high temperature properties. These are demonstrated by the fact that the decrease in glass transition temperature (Tg) exhibited as a result of the incorporation of a phosphoramide in the composition is substantially less than the corresponding decrease exhibited in blends containing, for example, phosphate esters such as bis(diaryl phosphates) of dihydroxyaromatic compounds. This is evident when a phosphoramide is compared to the organic phosphate ester in amounts suitable to provide enhanced flame resistance when measured, for example, in the UL-94 test procedure. In the case of phase-separated blends such as polycarbonate-ABS blends, the decrease in Tg is noted in the polycarbonate phase.

Experience has shown that the flame retarding properties of a phosphorus-based compound included in a resinous composition are generally proportional to the amount of phosphorus in the composition rather than to the amount of the compound itself. Thus, equal weights of two additives having different molecular weights but the same flame retarding properties may produce different UL-94 results, but amounts of the two additives which contribute the same proportion of phosphorus to the resinous composition will produce the same UL-94 results. On the other hand, other physical properties such as high temperature resistance are dependent on the amount of the compound itself and relatively independent of the phosphorus proportion therein. For this reason, the dependence of flame retarding and high temperature resistance of compositions containing two phosphorus-based compounds may not follow the same pattern.

It has been shown, however, with respect to the preferred phosphoramides employed according to the present invention that their superior properties of flame retardance and high temperature resistance are consistent. Thus, for example, proportions of resorcinol bis(di-2,6-xylyl phosphate) effective to confer a suitable flame-out time on certain resinous compositions are similar to those produced by a typical bis(2,6-xylyl)-phosphoramide at an essentially equivalent level of phosphorus, but the bisphosphoramide has a substantially lower tendency to decrease heat deflection temperature (HDT) despite the slightly greater amount of the bulk additive.

It should be clear that the present invention also affords methods to increase the heat distortion temperature of flame resistant compositions containing an amount of at least one phosphoramide and at least one adjunct flame retardant effective to render the composition a flame rating of at least V-2, preferably of at least V-1, most preferably V-0, in the UL-94 protocol, wherein the method comprises combining at least one thermoplastic resin, at least one phosphoramide having a glass transition point of at least about 0°C, preferably of at least about 10°C, and most preferably of at least about 20°C; and at least one adjunct flame retardant. In a preferred embodiment the invention also affords methods to increase the heat distortion temperature of chlorine-free and bromine-free, flame resistant compositions as described in the previous sentence. The method may be used to increase the heat distortion temperature of compositions comprising essentially a single phosphoramide or a mixture of two or more different types of phosphoramide; and those comprising essentially a single adjunct flame retardant, or a mixture of two or more different types of adjunct flame retardant. Compositions containing essentially a single phosphoramide and a single adjunct flame retardant are often preferred. Useful thermoplastic resins have been described herein. Especially preferred thermoplastic resins are polycarbonate, most especially bisphenol A- based polycarbonate, and blends of polycarbonate, especially polycarbonate-SAN-ABS blends, and polycarbonate-ABS blends, in which the amount of ABS may typically vary from about 1 to about 45 wt. %. An especially preferred phosphoramide is N,N'-bis-[di-(2,6-xylyl)-phosphoryl]-piperazine. It should also be clear that the present invention includes compositions made by the methods as well as articles made from the compositions.

Preparation methods for the compositions of the invention are typical of those employed for resinous blends. They may include such steps as dry blending followed by melt processing, the latter operation frequently being performed under continuous conditions as by extrusion. Following melt processing, the compositions are molded into test specimens by conventional means such as injection molding.

The addition of at least one phosphoramide and at least one adjunct flame retardant to the compositions of the present invention may be by mixing all of the blend components together prior to melt processing. Alternatively, either one of, or both of at least one phosphoramide and at least one adjunct flame retardant may be combined with at least one resinous blend component as a concentrate in a prior processing step. Such concentrates are often made by melt processing. The concentrate may then be combined with the remaining blend components.

The various embodiments of the invention are inclusive of simple blends comprising at least one thermoplastic resin and at least one phosphoramide and at least one adjunct flame retardant, and also of compositions in which one or more of said materials has undergone chemical reaction, either by itself or in combination with another blend component. When proportions are specified, they apply to the originally incorporated materials rather than those remaining after any such reaction.

In another of its embodiments the present invention comprises articles of manufacture made from the instantly disclosed compositions. Such articles may be transparent, translucent, or opaque depending upon the blend composition. Said articles can be made by any convenient means known in the art. Typical means include, but are not limited to, injection molding, thermoforming, blow molding, and calendering. Especially preferred articles include indirect and direct wound deflection yokes for all cathode ray tube applications including television and computer monitors, slit type deflection yokes, mold coil deflection yokes, television backplates, docking stations, pedestals, bezels, pallets, electronic equipment such as switches, switch housings, plugs, plug housings, electrical connectors, connecting devices, sockets; housings for electronic equipment such as television cabinets, computer housings, including desk-top computers, portable computers, lap-top computers, palm-held computers; monitor housings, printer housings, keyboards, FAX machine housings, copier housings, telephone housings, mobile phone housings, radio sender and/or receiver housings, lights and lighting fixtures, battery chargers, battery housings, antenna housings, transformers, modems, cartridges, network interface devices, circuit breakers, meter housings, panels for wet and dry appliances such as dishwashers, clothes washers, clothes dryers, refrigerators; heating and ventilation enclosures, fans, air conditioner housings, cladding and seating for indoor and outdoor application such as public transportation including trains, subways, buses; automotive electrical components.

The invention is illustrated by the following examples. All parts and percentages are by weight. Intrinsic viscosity was determined in chloroform at 25°C. HDT values were determined at 264 psi (1820 kPa) according to ASTM procedure D648. Examples 5-9 and 11-41 are comparative.

### EXAMPLE 1

Blends of various amounts of a bisphenol A homopolycarbonate, 6.5 parts of a commercially available high rubber graft ABS copolymer and 9 parts of a commercially available SAN copolymer were prepared under identical conditions by blending in a Henschel mixer followed by extrusion on a twin screw extruder and were molded into test specimens. The blends also contained conventional additives including 0.4 part of polytetrafluoroethylene dispersed within styrene-acrylonitrile copolymer as an anti-drip agent, which were not considered in determining proportions, and various amounts of the following phosphoryl-based flame retardant additives: N,N'-bis-[di-(2,6-xylyl)phosphoryl]piperazine (XPP), a compound according to formula VI : 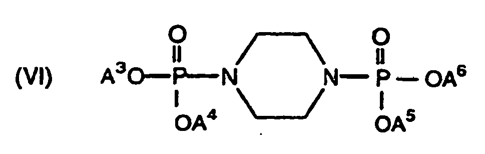 wherein each A moiety is a 2,6-dimethylphenyl residue; N,N'-bis(neopentylenedioxy phosphoryl)piperazine (NPP), a compound of similar structure but wherein each pair of A moieties on each phosphorus atom (e.g. the A3 and A4 pair) is a bridging neopentyl residue; N,N'-bis(diphenyl phosphoryl)piperazine (PPP), a compound of similar structure but wherein each A moiety is a phenyl residue; and resorcinol bis(diphenyl phosphate) (RDP) and bisphenol A bis(diphenyl phosphate) (BPADP), two conventional phosphate esters. The FOT (total flameout times for first and second ignitions for 5 bars of 0.125 inch thickness) and Tg of the polycarbonate phase of each test specimen was determined and the results are given in Table I.

**TABLE I**

| Sample | Base | 1 | 2 | 3 | 4 | 5 |
|---|---|---|---|---|---|---|
| Polycarbonate, parts | 81.3 | 72.2 | 76.9 | 73.9 | 73.6 | 71.6 |
| FR, identity | none | XPP | NPP | PPP | RDP | BPAD P |
| FR, phr | 0 | 12.4 | 6.9 | 10.4 | 10.7 | 13.2 |
| FR, phr P | 0 | 1.16 | 1.11 | | 0.97 | 1.02 |
| FR, %P | 0 | 1.02 | 1.01 | 1.04 | 1.03. | 1.04 |
| FOT, sec | burns | 19.4 | 84 | -- | 20.3 | 27.3 |
| Tg, °C | 147 | 131 | 149 | 121 | 111 | 112 |

It is apparent that the compositions of this invention had an significantly reduced FOT and a Tg that differed from that of polycarbonate (147°C) in a base composition not containing a phosphoramide or phosphate ester by an acceptable increment. Sample 2 had a Tg essentially equal within experimental error to that of the polycarbonate in the base composition but the FOT was appreciably higher than that obtained with XPP. Sample 3 utilizing PPP had a significantly lower Tg that that of XPP and NPP, yet exhibited similar FOT as obtained with XPP. It was unexpected that XPP-containing compositions (e.g., sample 1) would exhibit such superior FOT as compared to NPP-containing compositions (e.g., sample 2), and such a large increase in polycarbonate Tg as compared to PPP-containing compositions (e.g., sample 3). Samples 4 and 5, employing conventional flame retardants (FR), had unacceptably low Tg's for many commercial applications. The variations in FR content in terms of phr of total FR and of phosphorus are not considered significant from the standpoint of properties.

### EXAMPLE 2

In the same base composition used for Example 1, a composition was made containing 4.5 parts RDP and 5.7 XPP. The resultant composition has a flame out time of 17 seconds and the polycarbonate had a Tg of 127°C. The glass transition temperature is higher for this composition that would be expected based upon the results obtained in samples 1 and 4.

### EXAMPLE 3

Blends of 62 parts of a commercially available poly(2,6-dimethyl-1,4-phenylene ether) and 38 parts of a commercially available HIPS were prepared and molded under identical conditions similar to those of Example 1. The blends also contained conventional additives including 0.21 part of a polytetrafluoroethylene/styrene-acrylonitrile copolymer as an anti-drip agent, which were not considered in determining proportions, and 20.5 phr of XPP, RDP and BPADP as phosphoryl-based flame retardant additives. The FOT (total flameout times for first and second ignitions for 5 bars of 0.06 inch thickness) and heat deflection temperature (HDT) of each test specimen was determined and the results are given in Table II.

**TABLE II**

| Sample | 6 | 7 | 8 |
|---|---|---|---|
| FR, identity | XPP | RDP | BPADP |
| FR, phr P | 1.92 | 1.85 | 1.58 |
| FOT, sec | 24 | 21 | 37 |
| HDT, °C | 223.9 | 177.9 | 190.5 |

Again, it is apparent that the composition of the invention (Sample 6) had acceptable FR properties and a significantly higher HDT than the compositions containing conventional FR additives, indicating superior high temperature properties.

### EXAMPLE 4

A blend of 40 parts of a commercially available poly(2,6-dimethyl-1,4-phenylene ether) and 60 parts of a commercially available HIPS were prepared and molded under conditions similar to those of Example 3, using N,N'-bis[di-(2,6-xylyl)phosphoryl]piperazine (XPP) as the flame retardant material in essentially the same proportion. The observed FOT was 34 seconds.

### EXAMPLE 5

A commercially available HIPS, optionally containing poly(2,6-dimethyl-1,4-phenylene ether) and / or a polystyrene-polybutadiene-polystyrene elastomer, were prepared and molded under conditions similar to those of Example 1, using N,N'-bis[di-(2,6-xylyl)phosphoryl]piperazine (XPP) as the flame retardant material. The compositions and flame out times (FOT, as defined above for Table 1) are provided in Table III.

**TABLE III**

| Sample | Base | 9 | 10 | 11 | 12 | 13 |
|---|---|---|---|---|---|---|
| HIPS, parts | 100 | 90 | 70 | 65 | 72 | 78.5 |
| PPE, parts | 0 | 0 | 0 | 25 | 7 | 3.5 |
| Rubber, parts | 0 | 0 | 0 | 0 | 2 | 3.5 |
| XPP, parts | 0 | 10 | 30 | 10 | 19 | 14 |
| FOT, sec | burns | 320 | 135 | 400 | 215 | 315 |
| HDT, °C, 264 psi | 86 | 74 | 68 | 79 | 71 | 73 |

As seen by the above data, phosphoramides as described herein are effective in reducing the flame out time of HIPS, optionally in the presence of PPE and /or rubber. It was unexpected that the flame out times would be so dramatically improved, i.e. decreased, with the addition of the phosphoramide to render the material V-2 under UL-94 classification. It was also unexpected that the HDT would be so high for the compositions containing the phosphoramide.

### EXAMPLE 6

Blends of 90 parts of a commercially available bisphenol A polycarbonate were prepared containing 10 parts of either RDP or XPP. The blends also contained conventional additives, including a UV screener and an antioxidant, which were not considered in determining proportions. The compositions were extruded and molded into transparent specimens. Optical properties (according to ASTM 1003-61), including % transmission, yellowness index, and haze, and the Tg of the polycarbonate phase were determined for test specimens of each blend. The results are given in Table IV along with results for a comparable composition containing essentially 100% of the same polycarbonate and no added flame retardant.

**TABLE IV**

| Sample | Base | 14 | 15 |
|---|---|---|---|
| Polycarbonate | 100 | 90 | 90 |
| RDP | 0 | 10 | 0 |
| XPP | 0 | 0 | 10 |
| Tg, °C | 149 | 111 | 131 |
| Transmission, % | 90.1 | 88.3 | 89.5 |
| Haze | 0.7 | 3.3 | 0.7 |
| Yellowness index | 2.24 | 3.18 | 4.16 |

The above data show that the composition containing XPP has the same % transmission and haze as a specimen of essentially pure polycarbonate, and an acceptable yellowness index. Compared to the base sample, the decrease in polycarbonate Tg is only 18°C for the specimen containing XPP compared to 38°C for the specimen containing RDP.

### EXAMPLE 7

A blend of 26.5 parts of a first bisphenol A homopoly-carbonate, 61.8 parts of a second bisphenol A homopolycarbonate with weight average molecular weight about 71% of that of the first bisphenol A homopolycarbonate, 4 parts of a commercially available bulk ABS copolymer, and 5 parts XPP was prepared by blending in a Henschel mixer followed by extrusion on a twin screw extruder and molded into test specimens. The blend also contained 2.75 parts conventional additives including titanium dioxide and polytetrafluoro-ethylene dispersed within styrene-acrylonitrile copolymer as an anti-drip agent. Measurement of the Melt Volume Rate (260°C and 5 kilograms applied weight) for the blend gave a value of 24.9 cubic centimeters per 10 minutes. The blend showed a melt viscosity at 280°C of 390 Pascal-seconds (Pa-s) at a shear rate of 100 sec⁻¹, 220 Pa-s at a shear rate of 1500 sec⁻¹, and 72 Pa-s at a shear rate of 10000 sec⁻¹. The observed FOT (total flameout times for first and second ignitions for 5 bars of 0.06 inch thickness) was 21.5 seconds. A Ball Pressure Test run on test specimens at 125°C according to test protocol IEC 695-10-2 (1995-08) gave puncture diameter of 1.6 millimeters (mm). Typically, a value of less than 2 mm is desirable for most applications.

### EXAMPLE 8

A blend of 64.3 parts bisphenol A homopolycarbonate, 16 parts of a copolycarbonate comprising 45 mole % bisphenol A and 55 mole % 4,4'-(3,3,5-triinethylcyclohexylidene)diphenol (APEC 9371 obtained from Bayer Corp.); 4 parts of a commercially available high rubber graft ABS copolymer; 6 parts of a commercially available SAN copolymer, and 9 parts XPP was prepared by blending in a Henschel mixer followed by extrusion on a twin screw extruder and molded into test specimens. The blend also contained 0.7 parts of conventional additives including polytetrafluoroethylene dispersed within styrene-acrylonitrile copolymer as an anti-drip agent. The blend showed a glass transition temperature of 139°C. The observed FOT (total flameout times for first and second ignitions for 5 bars of 0.06 inch thickness) was 24 seconds.

### EXAMPLE 9

The same composition of Example 8 was prepared except that 16 parts of a copolycarbonate comprising 65 mole % bisphenol A and 35 mole % 4,4'-(3,3,5-trimethylcyclo-hexylidene)diphenol (APEC 9351 obtained from Bayer Corp.) was used. The blend showed a glass transition temperature of 140°C. The observed FOT (total flameout times for first and second ignitions for 5 bars of 0.06 inch thickness) was 21 seconds.

### EXAMPLE 10

A blend of 58.8 parts bisphenol A homopolycarbonate, 25 parts of a copolycarbonate comprising 65 mole % bisphenol A and 35 mole % 4,4'-(3,3,5-trimethylcyclohexylidene)diphenol (APEC 9351 obtained from Bayer Corp.); 4 parts of a commercially available high rubber graft ABS copolymer; 2 parts of a commercially available SAN copolymer, 0.5 parts CLAYTONE HY, and 9 parts XPP was prepared by blending in a Henschel mixer followed by extrusion on a twin screw extruder and molded into test specimens. The blend also contained 0.7 parts of conventional additives including polytetrafluoroethylene dispersed within styrene-acrylonitrile copolymer as an anti-drip agent. The blend showed a glass transition temperature of 140°C. The observed FOT (total flameout times for first and second ignitions for 5 bars of 0.06 inch thickness) was 19 seconds.

### EXAMPLES 11-25

Blends of 88 parts of a commercially available bisphenol A homopolycarbonate, 6 parts of a commercially available high rubber graft ABS copolymer and 4.5 parts of a commercially available SAN copolymer were prepared under conditions similar to those used for Example 1. The blends also contained conventional additives, including 0.5 part of polytetrafluoroethylene dispersed within styrene-acrylonitrile copolymer as an anti-drip agent, which were not considered in determining proportions. The blends also contained various amounts (in phr) of XPP and adjunct flame retardants. The compositions, flame out times (FOT, as defined above for Table I), and UL-94 ratings are provided in Table V.

**Table V**

| Material, phr | 11 | 12 | 13 | 14 | 15 | 16 | 17 | 18 | 19 | 20 | 21 | 22 | 23 | 24 | 25 |
|---|---|---|---|---|---|---|---|---|---|---|---|---|---|---|---|
| | | | | | | | | | | | | | | | |
| XPP | 10.4 | 8.1 | 8.1 | 8.2 | 8.3 | 8.1 | 8.1 | 8.2 | 8.1 | 8.1 | 8.1 | 8.1 | 8-2 | 8.3 | 8.5 |
| antimony oxide | 0 | 0 | 0.5 | 1.1 | 2.2 | 0 | 0 | 0 | 0 | 0 | 0 | 0 | 0 | 0 | 0 |
| boron phosphate | 0 | 0 | 0 | 0 | 0 | 0.27 | 0.55 | 1.1 | 0 | 0 | 0 | 0 | 0 | 0 | 0 |
| OrganoclayHY | 0 | 0 | 0 | 0 | 0 | 0 | 0 | 0 | 0.27 | 0.55 | 0 | 0 | 0 | 0 | 0 |
| Organoclay APA | 0 | 0 | 0 | 0 | 0 | 0 | 0 | 0 | 0 | 0 | 0.27 | 0.55 | 0 | 0 | 0 |
| PPS* | 0 | 0 | 0 | 0 | 0 | 0 | 0 | 0 | 0 | 0 | 0 | 0 | 1.1 | 2.2 | 4.6 |
| | | | | | | | | | | | | | | | |
| FOT.sec. | 30 | 70 | 20 | 4 | 109 | 30 | 42 | 35 | 7 | 35 | 15 | 27 | 24 | 53 | 67 |
| UL 94 rating | V-0 | V-1 | V-0 | V-0 | V-2 | V-0 | V-1 | V-1 | V-0 | V-1 | V-0 | V-1 | V-0 | V-1 | V-1 |

### • PPS = polyphenylene sulfide

Samples 11 and 12 are control sample containing two different amounts of XPP and no adjunct flame retardant. It can be seen that the UL-94 rating changes from V-0 to V-1 when a lower amount of XPP is used in control sample 12. The samples containing adjunct flame retardant demonstrate that compositions with acceptable UL-94 ratings can be made by the method of the invention. Compositions containing certain amounts of adjunct flame retardant have UL-94 rating that is as good as the rating for the control sample 11 although they contain only as much XPP as control sample 12.

### EXAMPLES 26-32

Blends of 25 parts of a bisphenol A polycarbonate with weight average molecular weight about 30,000 and 75 parts of a bisphenol A polycarbonate with lower weight average molecular weight were prepared. The blends contained various amounts of XPP, and of potassium diphenylsulfone-3-sulfonate (referred to as "KSS") as adjunct flame retardant. The blends also contained conventional additives which were not considered in determining proportions. The compositions were extruded and molded into transparent specimens. The total flame out times for first and second ignitions for 5 bars of each sample were determined using bars of both of 0.060 inch thickness and of 0.125 inch thickness. Optical properties, including yellowness index (according to ASTM D1925) and haze (according to ASTM 1003), were determined for test specimens of each blend. The results are given in Table VI along with results for a control composition (sample 24) containing the same polycarbonate mixture and a commercially available brominated polycarbonate flame retardant (PC-B).

**TABLE VI**

| Material, phr | 26 | 27 | 28 | 29 | 30 | 31 | 32 |
|---|---|---|---|---|---|---|---|
| PC-B | 0.5 | 0 | 0 | 0 | 0 | 0 | 0 |
| KSS | 0.25 | 0.15 | 0.05 | 0.05 | 0.25 | 0.05 | 0.15 |
| XPP | 0 | 0.5 | 0.1 | 0.9 | 0.9 | 0.1 | 0.5 |
| | | | | | | | |
| FOT-a, sec. | 19 | 26 | 36 | 64 | 61 | 25 | 35 |
| FOT-b, sec. | 24 | 34 | 56 | 83 | 31 | 48 | 53 |
| | | | | | | | |
| Yellowness Index | 2 | 2.5 | 2.3 | 2.8 | 3.4 | 1.8 | 2 |
| Haze | 1 | 0.6 | 0.7 | 0.5 | 1 | 0.5 | 0.5 |

| | | | | | | | |
|---|---|---|---|---|---|---|---|
| FOT-a = measured on 0.125 inch thickness test bars FOT-b = measured on 0.060 inch thickness test bars | | | | | | | |

The data show that samples with acceptable FOT values can be made by the method of the invention. Samples containing XPP and adjunct flame retardant demonstrate optical properties comparable to those for a similar blend containing only a commercially available brominated flame retardant.

### EXAMPLES 33-41

Blends of a commercially available bisphenol A homopolycarbonate, a commercially available high rubber graft ABS copolymer and a commercially available SAN copolymer were prepared under conditions similar to those used for Example 1. The blends also contained 0.7 part of conventional additives, including polytetrafluoroethylene dispersed within styrene-acrylonitrile copolymer as an anti-drip agent, which were not considered in determining proportions. The blends also contained various amounts (in phr) of XPP, CLAYTONE HY, and a commercially available polyphenylsulfone (RADEL R available from Amoco Chemical Co.) as adjunct flame retardants. The compositions, flame out times (FOT, as defined above for Table I), UL-94 ratings, and Limiting Oxygen Indices are provided in Table VII.

**TABLE VII**

| Material | 33 | 34 | 35 | 36 | 37 | 38 | 39 | 40 | 41 |
|---|---|---|---|---|---|---|---|---|---|
| | | | | | | | | | |
| PC | 77.8 | 70.3 | 77.8 | 73.8 | 65.8 | 73.8 | 77.8 | 77.8 | 79.3 |
| ABS | 4 | 8 | 4 | 4 | 8 | 4 | 4 | 8 | 7 |
| SAN | 6 | 2 | 2 | 6 | 6 | 6 | 2 | 6 | 2 |
| XPP | 9 | 9 | 5 | 5.5 | 9 | 5.5 | 5 | 5 | 9 |
| Organoclay HY | 0.5 | 0 | 0.5 | 0 | 0.5 | 0 | 0.5 | 0.5 | 0 |
| PPSO* | 2 | 10 | 10 | 10 | 10 | 10 | 10 | 2 | 2 |
| | | | | | | | | | |
| FOT, sec. | 14 | 30 | 30 | 70 | 53 | 52 | 43 | 240 | 24 |
| UL 94 rating | V-0 | V-0 | V-0 | V-1 | V-1 | V-1 | V-1 | -- | V-0 |
| LOI | 34 | -- | 35.9 | -- | -- | -- | -- | 30 | -- |

| | | | | | | | | | |
|---|---|---|---|---|---|---|---|---|---|
| * polyphenylsulfone | | | | | | | | | |

## Claims

1. A resin composition comprising the following and any reaction products thereof:
a) a thermoplastic resin selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin, and
b) at least one phosphoramide having a glass transition point of at least 0°C of the formula: 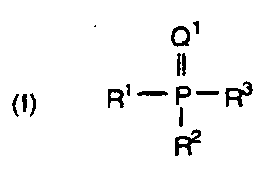 wherein:
Q1 is oxygen or sulfur;
R1 is an amine residue; and
R2 and R3 are each independently an alkyloxy, alkylthio, aryloxy, or arylthio residue, or an aryloxy or arylthio residue containing at least one alkyl substitution; or an amine residue; and
c) at least one adjunct flame retardant compound comprising at least one polymeric or non-polymeric member selected from the group consisting of phosphate esters, thiophosphate esters, phosphonate esters, thiophosphonate esters, phosphinate esters, thiophosphinate esters, phosphines, phosphine oxides, thiophosphine oxides and phosphonium salts.

2. The composition of claim 1 wherein at least one phosphoramide has a glass transition point of at least 10°C.

3. The composition of claim 1 wherein all of the phosphoramide of component b) has a glass transition point of at least 10°C.

4. The composition of claim 1 wherein at least one phosphoramide has a glass transition point of at least 20°C.

5. The composition of claim 1 wherein all of the phosphoramide of component b) has a glass transition point of at least 20°C.

6. The composition of claim 1 wherein the thermoplastic resin is selected from the group consisting of high impact polystyrene resin, syndiotactic polystyrene, polyphenylene ether / high impact polystyrene resin blends, polyphenylene ether / syndiotactic polystyrene resin blends, polycarbonate-SAN blends, polycarbonate-ABS blends, polycarbonate-SAN-ABS blends, and polycarbonate-polyester blends.

7. The composition of claim 1 wherein the thermoplastic resin is at least one of polycarbonates, polyphenylene ethers, high impact polystyrenes, syndiotactic polystyrenes, acrylonitrile-butadiene-styrene copolymers, and styrene-acrylonitrite copolymers.

8. The composition of claim 1 wherein the thermoplastic resin comprises at least one polycarbonate and ABS.

9. The composition of claim 8 wherein the at least one polycarbonate comprises bisphenol A polycarbonate and a copolycarbonate of bisphenol A and 4,4'-(3,3,5-trimethylcycto-hexytidene)diphenol.

10. The composition of claim 8 wherein the at least one phosphoramide comprises a phosphoramide of the formula VI : 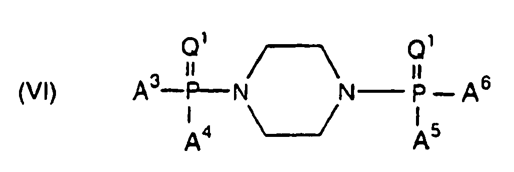 wherein each Q1 is independently oxygen or sulfur; and each A moiety is a 2,6-dimethylphenoxy moiety or a 2,4,6-trimethylphenoxy moiety.

11. The composition of claim 8 wherein the at least one phosphoramide comprises a phosphoramide of the formula VI : 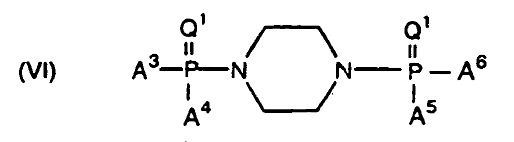 wherein each Q1 is oxygen; and each A moiety is a 2,6-dimethylphenoxy moiety.

12. The composition of claim 1 wherein the thermoplastic resin comprises polyphenylene ether and high impact polystyrene resin.

13. The composition of claim 1 wherein the at least one phosphoramide comprises a phosphoramide of the formula VI : 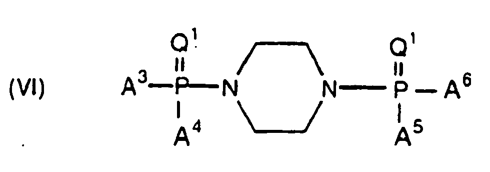 wherein each Q1 is independently oxygen or sulfur; and each A moiety is a 2,6-dimethylphenoxy moiety or a 2,4,6-trimethylphenoxy moiety.

14. The composition of claim 1 wherein the at least one phosphoramide comprises a phosphoramide of the formula VI : 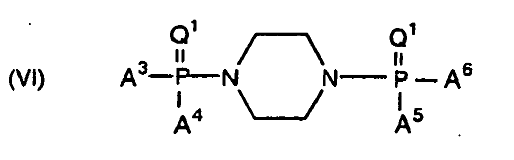 wherein each Q1 is oxygen; and each A moiety is a 2,6-dimethylphenoxy moiety.

15. The composition of claim 1 wherein the adjunct flame retardant comprises at least one member selected from the group consisting of resorcinol bis(diphepylphosphate), bisphenol A bis(diphenylphosphate), triphenylphosphateol and tricresylphosphate.

16. The composition of claim 1 wherein the combination of phosphoramide and adjunct flame retardant is present in an amount effective to render the resin composition a flame rating of V-0, V-1, or V-2 in the Underwriter's Laboratory UL-94 protocol when measured on a test specimen of 0.3175 cm (0.125 inch) by 1,27 cm (0.5 inch) by 147 cm (5 inch) dimensions.

17. The composition of claim 1 wherein at least one phosphoramide comprises a phosphoramide of the formula VI: 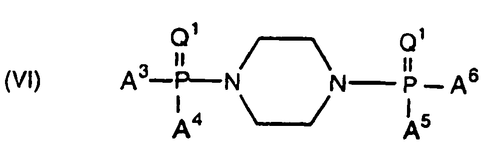 wherein each Q1 is independently oxygen or sulfur, and each A moiety is a 2,6-dimethylphenoxy moiety or a 2,4,6-trimethylphenoxy moiety.

18. The composition of claim 1 wherein at least one phosphoramide comprises a phosphoramide of the formula VI: 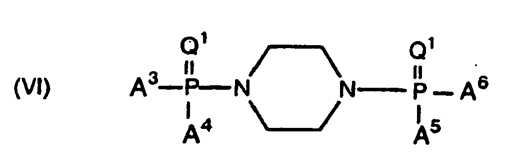 wherein each Q1 is oxygen; and each A moiety is a 2,6-dimethylphenoxy moiety.

19. The composition of claim 1 wherein at least one phosphoramide is present in an amount effective to render the resin composition a flame rating of V-0, V-1, or V-2 in the Underwriter's Laboratory UL-94 protocol when measured on a test specimen of 0.3175 cm (0.125 inch) by 1,27cm (0.5 inch) by 12.7cm (5 inch)dimensions.

20. The composition of claim 1 wherein the total amount of phosphorus per 100 parts of resinous materials is in the range of 0.008-3 parts by weight.

21. The composition of claim 1 which is essentially free of chlorine and bromine.

22. The composition of claim 1 wherein R1 is of the formula X : 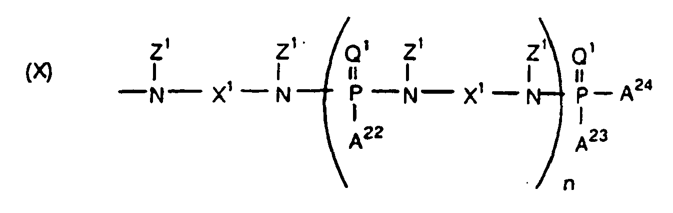 wherein
each Q1 is independently oxygen or sulfur;
each of A22-24 is independently an alkyloxy, alkylthio, aryloxy, or arylthio residue, or an aryloxy or arylthio residue containing at least one alkyl substitution; or an amine residue;
each Z1 is an alkyl radical, aromatic radical, or aromatic radical containing at least one alkyl substitution;
each X1 is an alkylidene radical, aromatic radical, or aromatic radical containing at least one alkyl substitution;
n is from 0 to 5; and
R2 and R3 are each independently an alkyloxy, alkylthio, aryloxy, or arylthio residue, or an aryloxy or arylthio residue containing at least one alkyl substitution; or an amine residue.

23. The composition of claim 1 wherein R1 is of the formula XI: 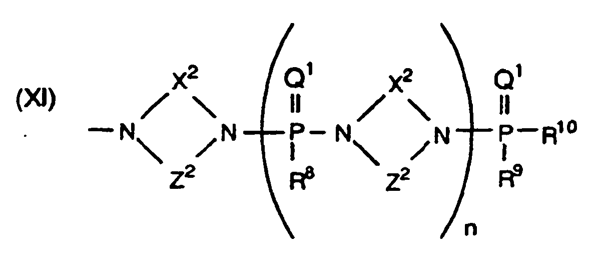 wherein
each Q1 is independently oxygen or sulfur;
each X2 is alkylidene, aryl, or alkaryl;
each Z2 is alkylidene;
each of R8, R9, and R10 is independently an alkyloxy residue, an aryloxy residue, an aryloxy residue containing at least one alkyl substitution, or an amine residue; and
n is from 0 to 5; and
R₂ and R3 are each independently an alkyloxy, alkylthio, aryloxy, or arylthio residue, or an aryloxy or arylthio residue containing at least one alkyl substitution; or an amine residue.

24. The composition of claim 1 wherein the
at least one phosphoramide having a glass transition point of at least 0°C is of the formula VIII : 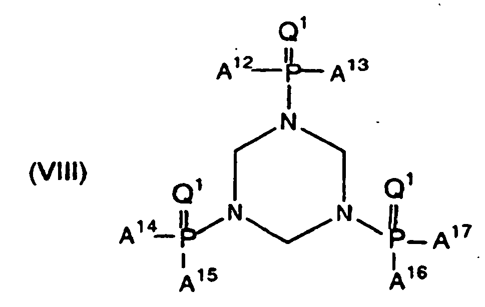 wherein
each Q1 is independently oxygen or sulfur; and
each of A12-17 is independently an alkyloxy, alkylthio, aryloxy, or arylthio residue, or an aryloxy or arylthio residue containing at least one alkyl substitution; or an amine residue.

25. The composition of claim 1 wherein the
at least one cyclic phosphoramide having a glass transition point of at least 0°C is of the formula XII: 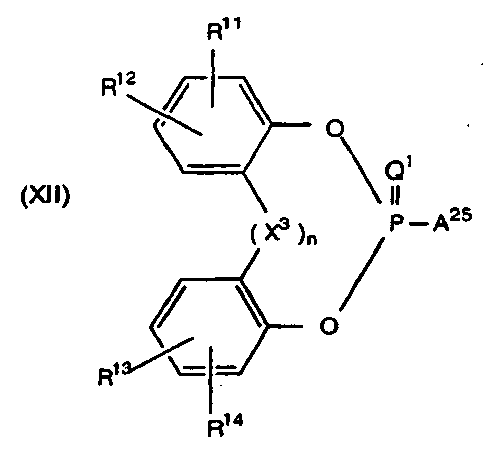 wherein Q1 is oxygen or sulfur;
each of R11-14 is independently a hydrogen or an alkyl radical;
X3 is a alkylidene radical;
n is 0 or 1; and
A25 is a group derived from a primary or secondary amine having the same or different radicals that can be aliphatic, alicyclic, aromatic, or alkaryl, or A25 is a group derived from a heterocyclic amine, or A25 is a hydrazine compound.

26. The composition of claim 1 wherein the
at least one bis(cyclic) phosphoramide having a glass transition point of at least 0°C is of the formula XIII : 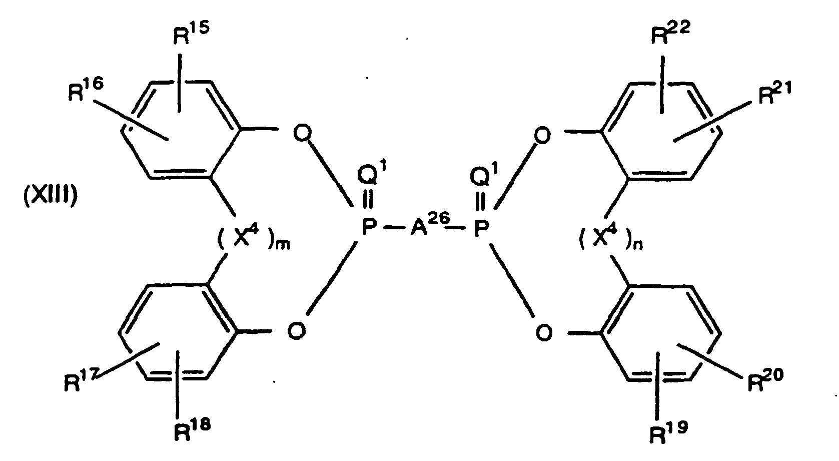
wherein each Q1 independently is oxygen or sulfur;
each of R15-22 is independently a hydrogen or an alkyl radical;
X4 is an alkylidene radical; m and n are each independently 0 or 1; and
A26 is 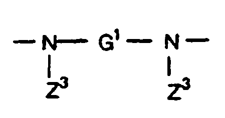
wherein G1 is sulfur, an alkylidene radical, aryl radical, or alkaryl radical; and each Z3 is independently an alkyl radical or an aryl radical; or wherein A26 is 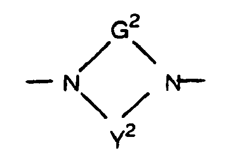 wherein G2 is alkylidene, aryl, or alkaryl, and Y2 is alkylidene.

27. A resin composition consisting essentially of:
a) a thermoplastic resin selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin, and
b) at least one phosphoramide having a glass transition point of at least 0°C of the formula: 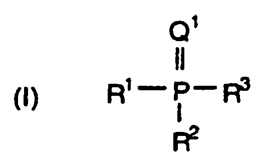 wherein
Q1 is oxygen or sulfur;
R1 is an amine residue, and
R2 and R3 are each independently an alkyloxy, alkylthio, aryloxy, or arylthio residue, or an aryloxy or arylthio residue containing at least one alkyl substitution; or an amine residue; and
c) at least one adjunct flame retardant compound, as defined in claim 1.

28. An article made from the composition of claim 1.

29. The article of claim 28 which is a deflection yoke for cathode ray tube, deflection yoke for television, slit type deflection yoke, mold coil deflection yoke, television backplate, docking station, pedestal, bezel, pallet, switch, switch housing, plug, plug housing, electrical connector, connecting device, socket, television housing, computer housing, desk-top computer housing, portable computer housing, lap-top computer housing, palm-held computer housing; monitor housing, printer housing, keyboard, FAX machine housing, copier housing, telephone housing, mobile phone housing, radio sender housing, radio receiver housing, light fixture, battery charger housing, battery housing, automotive electrical component, antenna housing, transformer housing, modem, cartridge, network interface device housing, circuit breaker housing, meter housing, panel for wet or dry appliance, dishwasher panel, clothes washer panel, clothes dryer panel, refrigerator panel; heating or ventilation enclosure, fan, air conditioner housing, cladding or seating for public transportation; or cladding or seating for trains, subways, or buses.

30. A method to increase the heat distortion temperature of a flame resistant composition containing an amount of at least one phosphoramide and at least one adjunct flame retardant effective to render the composition a flame rating of at least V-2 in the Underwriter's Laboratory UL-94 protocol when measured on a test specimen of 0.3175 cm (0.125 inch) by 1.27 cm (0.5 inch) by 12.7 cm (5 inch) dimensions, wherein the method comprises combining at least one thermoplastic resin, at least one phosphoramide having a glass transition point of at least 0°C, and at least one adjunct flame retardant, wherein the thermoplastic resin, phosphoramide and adjunct flame retardant are as defined in claim 1.

31. The method of claim 30 wherein the composition has a flame rating of least V-1.

32. The method of claim 30 wherein the composition has a flame rating of least V-0.

33. The method of claim 30 wherein at least one phosphoramide has a glass transition point of at least 10°C.

34. The method of claim 30 wherein the phosphoramide has a glass transition point of at least 10°C.

35. The method of claim 33 wherein at least one phosphoramide has a glass transition point of at least 20°C.

36. The method of claim 30 wherein the phosphoramide has a glass transition point of at least 20°C.

37. The method of claim 30 wherein the at least one phosphoramide comprises a phosphoramide of the formula VI : 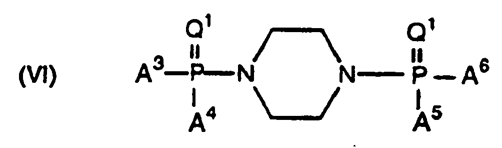 wherein each Q1 is independently oxygen or sulfur; and each A moiety is a 2,6-dimethylphenyl moiety or a 2,4,6-trimethylphenyl moiety.

38. The method of claim 30 wherein the thermoplastic resin is a polycarbonate resin or a blend containing at least one polycarbonate resin.

39. The method of claim 30 wherein the thermoplastic resin comprises at least one polycarbonate and ABS.

40. The method of claim 39 wherein the at least one polycarbonate comprises bisphenol A polycarbonate and a copolycarbonate of bisphenol A and 4,4'-(3,3,5-trimethytcyclo-hexylidene)diphenol.

41. The method of claim 30 wherein the adjunct flame retardant comprises at least one member selected from the group consisting of resorcinol bis(diphenylphosphate), bisphenol A bis(diphenylphosphate), triphenylphosphate and tricresylphosphate.

42. The method of claim 30 in which the composition is essentially free of chlorine and bromine.

43. The flame resistant composition of claim 42.

44. The flame resistant composition of claim 30.

45. A resin composition comprising the following and any reaction products thereof:
(a) at least one thermoplastic resin selected from the group consisting of (i) polycarbonate resins and blends containing at least one polycarbonate resin, (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin: (v) styrene-containing graft copolymer resin and blends containing styrene-containing graft copolymer resin,; and (vi) high impact polystyrene resin and blends containing high impact polystyrene resin, and
(b) a phosphoramide having a glass transition point of at least 20°C of the formula VI: 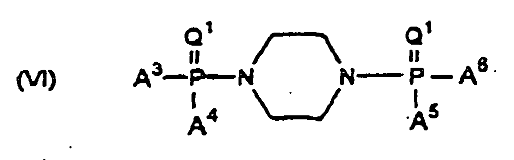 wherein each Q¹ is oxygen; and each A moiety is a 2,6-dimethylphenoxy moiety, and
(c) at least one polymeric or non-polymeric adjunct flame retardant compound selected from the group consisting of phosphate esters, phosphate salts, phosphonate esters, phosphonate salts, phosphinate esters, phosphinate salts, phosphines, phosphonium salts; phosphine oxides, pyrophosphate salts, metaphosphate salts, resorcinol bis(diphenylphosphate), bisphenol A bis(diphenylphosphate), triphenylphosphate and tricresylphosphate,

46. A method to increase the heat distortion temperature of a flame resistant composition containing an amount of at least one phosphoramide and at least one adjunct flame retardant effective to render the composition a flame rating of at least V-2 in the Underwriter's Laboratory UL-94 protocol when measured on a test specimen of 0.317 cm (0.125 inch) by 1,27 cm (0.5 inch) by 12,7 cm (5 inch) dimensions, wherein the method comprises combining
(a) at least one thermoplastic resin selected from the group consisting of i) polycarbonate resins and blends containing at least one polycarbonate resin. (ii) polyphenylene ether resins and blends containing at least one polyphenylene ether resin, (iii) polystyrene resin and blends containing polystyrene resin, (iv) styrene-containing copolymer resin and blends containing styrene-containing copolymer resin; (v) styrene-containing graft copolymer resin and blends containing styrene-containing graft copolymer resin; and (vi) high impact polystyrene resin and blends containing high impact polystyrene resin, and
(b) a phosphoramide having a glass transition point of at least 20°C of the formula VI: 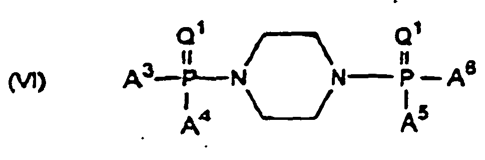 wherein each Q¹ is oxygen: and each A moiety is a 2.6-dimethylphenoxy moiety, and
(c) at least one polymeric or non-polymeric adjunct flame retardant compound selected from the group consisting of phosphate esters, phosphonate esters, phosphinate esters, phosphines, phosphine oxides, resorcinol bis(diphenylphosphate) bisphenol A bis(diphenylphosphate), triphenylphosphate and tricresylphosphate.

## Patentansprüche

1. Eine Harzzusammensetzung umfassend das Folgende und jegliche Reaktionsprodukte davon:
a) ein thermoplastisches Harz ausgewählt aus der Gruppe bestehend aus (i) Polycarbonatharzen und Mischungen enthaltend wenigstens ein Polycarbonatharz, (ii) Polyphenylenetherharzen und Mischungen enthaltend wenigstens ein Polyphenylenetherharz, (iii) Polystyrolharz und Mischungen enthaltend Polystyrolharz, (iv) Styrol enthaltendes Copolymerharz und Mischungen enthaltend Styrol enthaltendes Copolymerharz; (v) Styrol enthaltendes Pfropfcopolymerharz und Mischungen enthaltend Styrol enthaltendes Pfropfcopolymerharz; und (vi) hochschlagzähes Polystyrolharz und Mischungen enthaltend hochschlagzähes Polystyrolharz, und
b) wenigstens ein Phosphoramid mit einem Glasübergangspunkt von wenigstens 0°C mit der Formel: 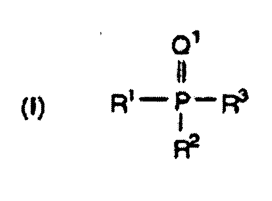 worin:
Q1 Sauerstoff oder Schwefel ist;
R1 ein Aminrest ist; und
R2 und R3 jeweils unabhängig ein Alkyloxy-, Alkylthio-, Aryloxy- oder Arylthiorest sind, oder ein Aryloxy- oder Arylthiorest der wenigstens eine Alkylsubstitution enthält; oder ein Aminrest; und
c) wenigstens eine Zusatz flammhemmende Verbindung umfassend wenigstens ein polymeres oder nicht-polymeres Mitglied ausgewählt aus der Gruppe bestehend aus Phosphatestern, Thiophosphatestern, Phosphonatestern, Thiophosphonatestern, Phosphinatestern, Thiophosphinatestem, Phosphinen, Phosphinoxiden, Thiophosphinoxiden und Phosphoniumsalzen.

2. Zusammensetzung nach Anspruch 1, wobei wenigstens ein Phsophoramid einen Glasübergangspunkt von wenigstens 10°C hat.

3. Zusammensetzung nach Anspruch 1, wobei das gesamte Phosphoramid des Bestandteils b) einen Glasübergangspunkt von wenigstens 10°C hat.

4. Zusammensetzung nach Anspruch 1, wobei wenigstens ein Phosphoramid einen Glasübergangspunkt von wenigstens 20°C hat.

5. Zusammensetzung nach Anspruch 1, wobei das gesamte Phosphoramid des Bestandteils b) einen Glasübergangspunkt von wenigstens 20°C hat.

6. Zusammensetzung nach Anspruch 1, wobei das thermoplastische Harz ausgewählt ist aus der Gruppe bestehend aus hochschlagzähem Polystyrolharz, syndiotaktischem Polystyrol, Polyphenylenether/hochschlagzähes Polystyrolharz-Mischungen, Polyphenylenether/syndiotaktisches Polystyrolharz-Mischungen, Polycarbonat-SAN-Mischungen, Polycarbonat-ABS-Mischungen, Polycarbonat-SAN-ABS-Mischungen und Polycarbonat-Polyestermischungen.

7. Zusammensetzung nach Anspruch 1, wobei das thermoplastische Harz wenigstens eins von Polycarbonaten, Polyphenylenethern, hochschlagzähen Polystyrolen, syndiotaktischen Polystyrolen, Acrylnitril-Butadienstyrol-Copolymeren und Styrol-Acrylnitril-Copolymeren ist.

8. Zusammensetzung nach Anspruch 1, wobei das thermoplastische Harz wenigstens ein Polycarbonat und ABS umfasst.

9. Zusammensetzung nach Anspruch 8, wobei wenigstens ein Polycarbonat Bisphenol A-Polycarbonat und ein Copolycarbonat des Bisphenols A und 4,4'-(3,3,5-Trimethylcyclo-hexyliden)diphenol umfasst.

10. Zusammensetzung nach Anspruch 8, wobei das wenigstens eine Phosphoramid ein Phosphoramid der Formel VI aufweist: 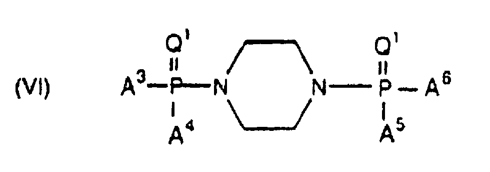 worin jedes Q1 unabhängig Sauerstoff oder Schwefel ist; und jeder Rest A ein 2,6-Dimethylphenoxyrest oder ein 2,4,6-Trimethylphenoxyrest ist.

11. Zusammensetzung nach Anspruch 8, wobei das wenigstens eine Phosphoramid ein Phosphoramid der Formel VI umfasst: 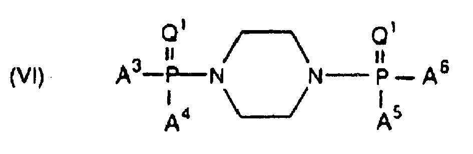 worin jedes Q1 Sauerstoff ist; und jeder Rest A ein 2,6-Dimethylphenoxyrest ist.

12. Zusammensetzung nach Anspruch 1, wobei das thermoplastische Harz Polyphenylenether und hochschlagzähes Polystyrolharz umfasst.

13. Zusammensetzung nach Anspruch 1, wobei das wenigstens eine Phosphoramid ein Phosphoramid der Formel VI umfasst: 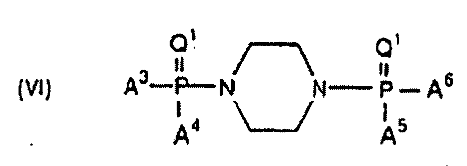 worin jedes Q1 unabhängig Sauerstoff oder Schwefel ist; und jeder Rest A ein 2,6-Dimehtylphenoxyrest oder ein 2,4,6-Trimethylphenoxyrest ist.

14. Zusammensetzung nach Anspruch 1, wobei das wenigstens eine Phosphoramid ein Phosphoramid der Formel VI umfasst: 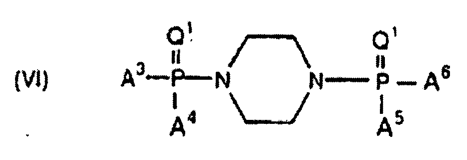 worin jedes Q1 Sauerstoff ist; und jeder Rest A ein 2,6-Dimethylphenoxyrest ist.

15. Zusammensetzung nach Anspruch 1, wobei der Zusatz-Flammhemmer wenigstens ein Mitglied aufweist ausgewählt aus der Gruppe bestehend aus Resorcin Bis(diphenylphosphat), Bisphenol-A bis(diphenylphosphat), Triphenylphosphat und Tricresylsphosphat.

16. Zusammensetzung nach Anspruch 1, wobei die Kombination aus Phosphoramid und Zusatz-Flammhemmer in einer wirksamen Menge vorhanden ist, um der Harzzusammensetzung eine Flammklasse von V-0, V-1 oder V-2 gemäß dem Underwriter's Laboratory UL-94-Protokoll zu verleihen, gemessen an einem Testkörper der Dimension 0,3175 cm (0,125 inch) mal 1,27 cm (0,5 inch) mal 12,7 cm (5 inch).

17. Zusammensetzung nach Anspruch 1, wobei wenigstens ein Phosphoramid ein Phosphoramid der Formel VI umfasst: 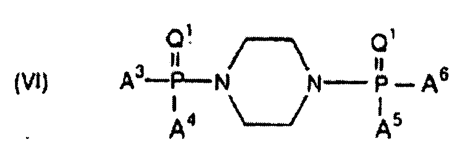 worin jedes Q1 unabhängig Sauerstoff oder Schwefel ist; und jeder Rest A ein 2,6-Dimethylphenoxyrest oder ein 2,4,6-Trimethylphenoxyrest ist.

18. Zusammensetzung nach Anspruch 1, wobei wenigstens ein Phosphoramid ein Phosphoramid der Formel VI umfasst: 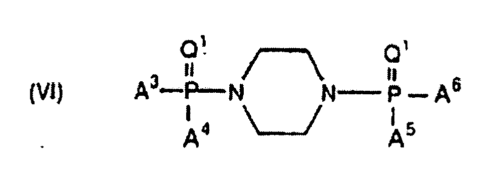 wobei jedes Q1 Sauerstoff ist; und jeder Rest A ein 2,6-Dimethylphenoxyrest ist.

19. Zusammensetzung nach Anspruch 1, wobei wenigstens ein Phosphoramid in einer wirksamen Menge vorhanden ist, um der Harzzusammensetzung eine Flammklasse V-0, V-1 oder V-2 gemäß Underwriter's Laboratory UL-94-Protokoll zu verleihen, gemessen an einem Testkörper der Dimension 0,3175 cm (0,125 inch) mal 1,27 cm (0,5 inch) mal 12,7cm (5 inch).

20. Zusammensetzung nach Anspruch 1, wobei die Gesamtmenge an Phosphor pro 100 Teilen des Harzmaterials im Bereich von 0,008-3 Gewichtsteilen ist.

21. Zusammensetzung nach Anspruch 1, im Wesentlichen frei von Chlor und Brom.

22. Zusammensetzung nach Anspruch 1, worin R1 die Formel X hat: 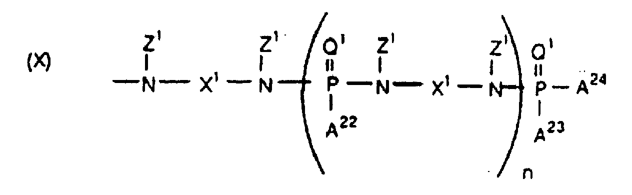 worin
jedes Q1 unabhängig Sauerstoff oder Schwefel ist;
jeder der Reste A22-24 unabhängig ein Alkyloxy-, Alkylthio-, Aryloxy- oder Arylthiorest ist, oder ein Aryloxy- oder Arylthiorest enthaltend wenigstens eine Alkylsubstitution, oder ein Aminrest;
jedes Z1 ein Alkylrest, aromatischer Rest, oder aromatischer Rest enthaltend wenigstens eine Alkylsubstitution ist;
jedes X1 ein Alkylidenrest, aromatischer Rest oder aromatischer Rest enthaltend wenigstens eine Alkylsubstitution ist;
n 0 bis 5 ist; und
R2 und R3 jeweils unabhängig ein Alkyloxy-, Alkylthio-, Aryloxy- oder Arylthiorest sind, oder ein Aryloxy oder Arylthiorest enthaltend wenigstens eine Alkylsubstitution; oder ein Aminrest.

23. Zusammensetzung nach Anspruch 1, wobei R1 die Formel XI hat: 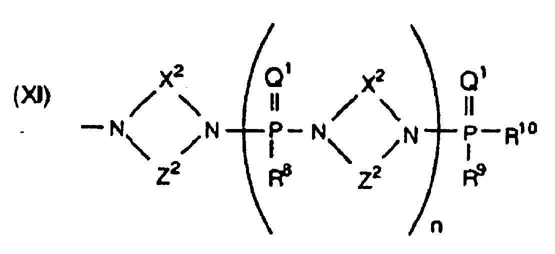 worin
jedes Q1 unabhängig Sauerstoff oder Schwefel ist;
jedes X2 Alkyliden, Aryl oder Alkaryl ist;
jedes Z2 Alkyliden ist;
jedes von R8, R9 und R10 unabhängig ein Alkyloxyrest, ein Aryloxyrest, ein Aryloxyrest enthaltend wenigstens eine Alkylsubstitution, oder ein Aminrest ist; und
n im Bereich von 0 bis 5 ist; und
R2 und R3 jeweils unabhängig ein Alkyloxy-, Alkylthio-, Aryloxy- oder Arylthiorest sind, oder ein Aryloxy- oder Arylthiorest enthaltend wenigstens eine Alkylsubsitution; oder ein Aminrest.

24. Die Zusammensetzung nach Anspruch 1, worin das wenigstens eine Phosphoramid, das einen Glasübergangspunkt von wenigstens 0°C hat, die Formel VIII hat: 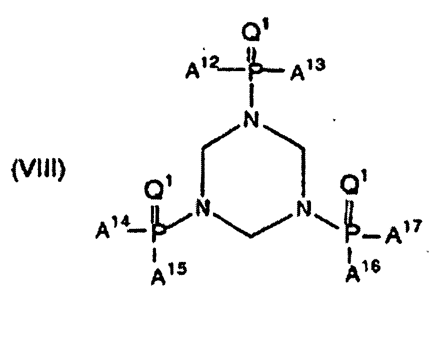 worin
jedes Q1 unabhängig Sauerstoff oder Schwefel ist; und
jedes von A12-17 unabhängig ein Alkyloxy-, Alkylthio-, Aryloxy- oder Arylthiorest ist, oder ein Aryloxy- oder Arylthiorest enthaltend wenigstens eine Alkylsubsitution; oder ein Aminrest.

25. Zusammensetzung nach Anspruch 1, wobei das wenigstens eine cyclische Phosphoramid, das einen Glasübergangspunkt von wenigstens 0°C hat, die Formel XII hat: 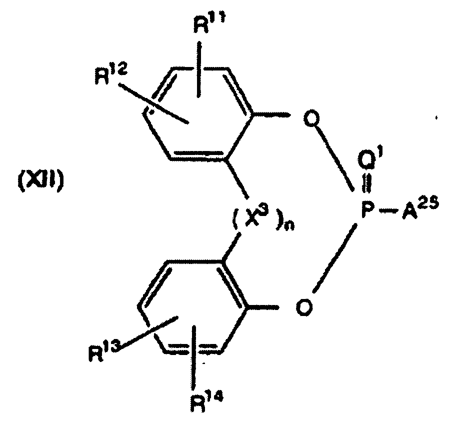 worin Q1 Sauerstoff oder Schwefel ist;
jedes von R11-14 unabhängig ein Wasserstoff oder ein Alkylrest ist;
X3 ein Alkylidenrest ist;
n 0 oder 1 ist; und
A25 eine Gruppe ist abgeleitet von einem primären oder sekundären Amin, welches dieselben oder verschiedene Reste hat, welche aliphatisch, alicyclisch, aromatisch oder Alkaryl sein können, oder A25 eine Gruppe ist abgeleitet von einem heterocyclischen Amin, oder A25 eine Hydrazinverbindung ist.

26. Die Zusammensetzung nach Anspruch 1, worin das wenigstens eine biscyclische Phsophoramid, das einen Glasübergangspunkt von wenigstens 0°C hat, die Formel XIII hat: 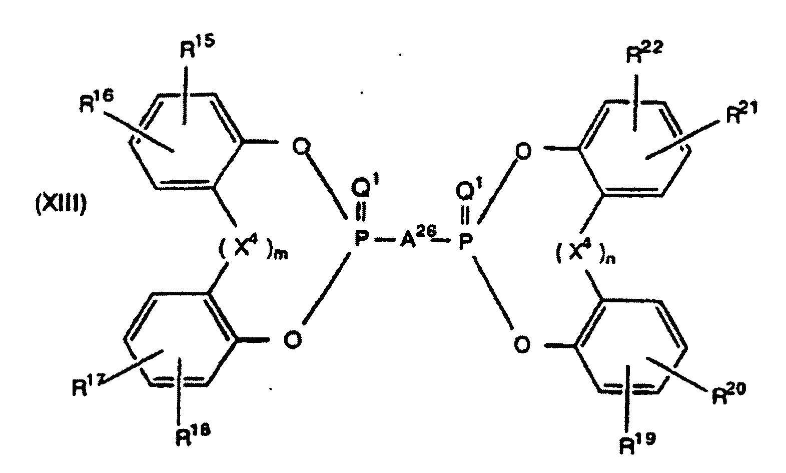 worin jedes Q1 unabhängig ein Sauerstoff oder Schwefel ist;
jedes von R15-22 unabhängig ein Wasserstoff oder ein Alkylrest ist;
X4 ein Alkylidenrest ist; m und n jeweils unabhängig 0 oder 1 sind; und A26 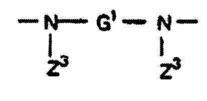
ist, worin G1 Schwefel ist, ein Alkylidenrest, Arylrest oder Alkarylrest; und jedes Z3 unabhängig ein Alkylrest oder ein Arylrest ist; oder worin A26 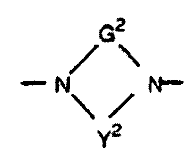
ist,
worin G2 ein Alkyliden, Aryl oder Alkaryl ist, und Y2 Alkyldiden ist.

27. Eine Harzzusammensetzung bestehend im wesentlichen aus:
a) einem thermoplastischen Harz ausgewählt aus der Gruppe bestehend aus (i) Polycarbonatharzen und Mischungen enthaltend wenigstens ein Polycarbonatharz, (ii) Polyphenylenetherharzen und Mischungen enthaltend wenigstens ein Polyphenylenetherharz, (iii) Polystyrolharz und Mischungen enthaltend Polystyrolharz, (iv) Styrol enthaltendes Copolymerharz und Mischungen enthaltend Styrol enthaltendes Copolymerharz; (v) Styrol enthaltendes Pfropfcopolymerharz und Mischungen enthaltend Styrol enthaltendes Pfropfcopolymerharz; und (vi) hochschlagzähes Polystyrolharz und Mischungen enthaltend hochschlagzähes Polystyrolharz, und
b) wenigstens ein Phosphoramid mit einem Glasübergangspunkt von wenigstens 0°C mit der Formel: 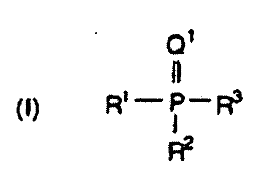 worin:
Q1 Sauerstoff oder Schwefel ist;
R1 ein Aminrest ist; und
R2 und R3 jeweils unabhängig ein Alkyloxy-, Alkylthio-, Aryloxy- oder Arylthiorest ist, oder ein Aryloxy- oder Arylthiorest, der wenigstens eine Alkylsubstitution enthält; oder ein Aminrest; und
c) wenigstens eine zugesetzte flammhemmende Verbindung wie in Anspruch 1 definiert.

28. Ein Gegenstand hergestellt aus der Zusammensetzung nach Anspruch 1.

29. Gegenstand nach Anspruch 28, bei welchem es sich um einen Ablenkbügel für eine Kathodenstrahlröhe, einen Ablenkbügel für einen Fernsehempfänger, einen Ablenkbügel vom Schlitztyp, Formspirale eines Ablenkbügels, Fernsehempfängerrückwand, Docking-Station, Bedienpult, Blende, Palette, Schalter, Schaltergehäuse, Stecker, Steckergehäuse, elektrischer Verbinder, Verbindungseinrichtung, Sockel, Fernsehempfängergehäuse, Computergehäuse, Desktop-Computergehäuse, Gehäuse eines tragbaren Computers, Gehäuse eines Laptop-Computers, Gehäuse eines Palmcomputers, Monitorgehäuse, Druckergehäuse, Keyboardgehäuse, Gehäuse eines Faxgerätes, Gehäuse eines Kopierers, Gehäuse eines Telefons, Gehäuse eines Mobiltelefons, Gehäuse eines Radiosenders, Gehäuse eines Radioempfängers, Leuchte, Gehäuse eines Batterieaufladegeräts, Batteriegehäuse, elektrische Komponenten eines Fahrzeugs, Antennengehäuse, Transformatorengehäuse, Modem, Kassette, Gehäuse einer Netzwerkinterfaceeinrichtung, Gehäuse eines Hauptschalters, Gehäuse eines Messgeräts, Bedieneinrichtung eines Haushaltsgeräts für die Feucht- oder Trockenanwendung, Bedieneinrichtung eines Geschirrspülers, Bedieneinrichtung einer Waschmaschine, Bedieneinrichtung für einen Wäschetrockner, Bedieneinrichtung eines Kühlschranks; Einfassung einer Heizung oder Ventilation, Gebläse, Gehäuse einer Klimaanlage, Überzug oder Sitz für den öffentlichen Transport; oder Überzug oder Sitz für Züge, U-Bahnen oder Busse handelt.

30. Verfahren zur Steigerung der Hitzeverformungstemperatur einer flammhemmenden Zusammensetzung enthaltend einen Gehalt an wenigstens einem Phosphoramid und wenigstens einen Zusatz-Flammhemmer, der bewirkt, dass die Zusammensetzung eine Flammklasse von wenigstens V-2 gemäß dem Underwriter's Laboratory UL-94-Protokoll hat, gemessen an einem Testkörper der Dimension 0,3175 cm (0,125 inch) mal 1,27 cm (0,5 inch) mal 12,7 cm (5 inch), wobei das Verfahren umfasst, dass man wenigstens ein thermoplastisches Harz, wenigstens ein Phosphoramid, das einen Glasübergangspunkt von wenigstens 0°C hat, und wenigstens einen zugesetzten Flammhemmer kombiniert, wobei das thermoplastische Harz, Phosphoramid und Zusatz-Flammhemmer wie in Anspruch 1 definiert sind.

31. Verfahren nach Anspruch 30, wobei die Zusammensetzung eine Flammklasse von wenigstens V-1 hat.

32. Verfahren nach Anspruch 30, wobei die Zusammensetzung eine Flammklasse von wenigstens V-0 hat.

33. Verfahren nach Anspruch 30, wobei wenigstens ein Phosphoramid einen Glasübergangspunkt von wenigstens 10°C hat.

34. Verfahren nach Anspruch 30, wobei das Phosphoramid einen Glasübergangspunkt von wenigstens 10°C hat.

35. Verfahren nach Anspruch 33, wobei wenigstens ein Phsophoramid einen Glasübergangspunkt von wenigstens 20°C hat.

36. Verfahren nach Anspruch 30, wobei das Phosphoramid einen Glasübergangspunkt von wenigstens 20°C hat.

37. Verfahren nach Anspruch 30, wobei das wenigstens eine Phosphoramid ein Phosphoramid der Formel VI umfasst: 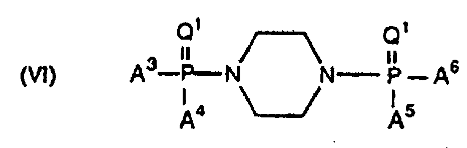 worin jedes Q1 unabhängig Sauerstoff oder Schwefel ist; jeder Rest A ein 2,6-Dimethylphenylrest oder ein 2,4,6-Trimethylphenylrest ist.

38. Verfahren nach Anspruch 30, wobei das thermosplastische Harz ein Polycarbonatharz oder eine Mischung ist enthaltend wenigstens ein Polycarbonatharz.

39. Verfahren nach Anspruch 30, wobei das thermoplastische Harz wenigstens ein Polycarbonat und ABS umfasst.

40. Verfahren nach Anspruch 39, wobei das wenigstens eine Polycarbonat Bisphenol A-Polycarbonat und ein Copolycarbonat aus Bisphenol A und 4,4'-(3,35-Trimethylcyclo-hexyliden)diphenol aufweist.

41. Verfahren nach Anspruch 30, wobei der Zusatz-Flammhemmer wenigstens einen Bestandteil aufweist ausgewählt aus der Gruppe bestehend aus Resorcin Bis(diphenylphosphat), Bisphenol-A bis(diphenylphosphat), Triphenylphosphat und Tricresylsphosphat.

42. Verfahren nach Anspruch 30, bei welchem die Zusammensetzung im wesentlichen frei von Chlor und Brom ist.

43. Die flammhemmende Zusammensetzung nach Anspruch 42.

44. Die flammhemmende Zusammensetzung nach Anspruch 30.

45. Eine Harzzusammensetzung umfassend das Folgende und jegliche Reaktionsprodukte davon:
(a) ein thermoplastisches Harz ausgewählt aus der Gruppe bestehend aus (i) Polycarbonatharzen und Mischungen enthaltend wenigstens ein Polycarbonatharz, (ii) Polyphenylenetherharzen und Mischungen enthaltend wenigstens ein Polyphenylenetherharz, (iii) Polystyrolharz und Mischungen enthaltend Polystyrolharz, (iv) Styrol enthaltendes Copolymerharz und Mischungen enthaltend Styrol enthaltendes Copolymerharz; (v) Styrol enthaltendes Pfropfcopolymerharz und Mischungen enthaltend Styrol enthaltendes Pfropfcopolymerharz; und (vi) hochschlagzähes Polystyrolharz und Mischungen enthaltend hochschlagzähes Polystyrolharz, und
(b) ein Phosphoramid mit einem Glasübergangspunkt von wenigstens 20°C mit der Formel: 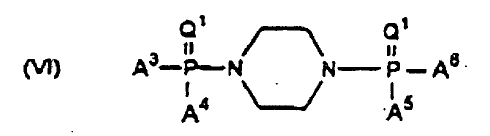 worin jedes Q¹ Sauerstoff ist und jeder Rest A ein 2,6-Dimethylohenoxyrest ist, und
(c) wenigstens eine polymere oder nicht-polymere Zusatz flammhemmende Verbindung ausgewählt aus der Gruppe bestehend aus Phosphatestern, Phosphatsalzen, Phosphonatestern, Phosphonatsalzen, Phosphinatestern, Phosphinatsalzen, Phosphinen, Phosphoniumsalzen; Phosphinoxiden, Pyrrophosphatsalzen, Metaphosphatsalzen, Resorcin Bis(diphenylphosphat), Bisphenol A bis(diphenylphosphat), Triphenylphosphat und Tricresylphsophat.

46. Ein Verfahren zur Steigerung der Wärmeverformbarkeitstemperatur einer flammhemmenden Zusammensetzung enthaltend einen Gehalt an wenigstens einem Phosphoramid und an wenigstens einem zugesetzten Flammhemmer, der bewirkt, dass die Zusammensetzung eine Flammklasse von wenigstens V-2 gemäß Underwriter's Laboratory UL-94-Protokoll erhält, gemessen an einem Testkörper der Dimensionen 0,3175 cm (0,125 inch) mal 1,27 cm (0,5 inch) mal 12,7 cm (5 inch), wobei das Verfahren umfasst, dass man miteinander kombiniert
(a) ein thermoplastisches Harz ausgewählt aus der Gruppe bestehend aus (i) Polycarbonatharzen und Mischungen enthaltend wenigstens ein Polycarbonatharz, (ii) Polyphenylenetherharzen und Mischungen enthaltend wenigstens ein Polyphenylenetherharz, (iii) Polystyrolharz und Mischungen enthaltend Polystyrolharz, (iv) Styrol enthaltendes Copolymerharz und Mischungen enthaltend Styrol enthaltendes Copolymerharz; (v) Styrol enthaltendes Pfropfcopolymerharz und Mischungen enthaltend Styrol enthaltendes Pfropfcopolymerharz; und (vi) hochschlagzähes Polystyrolharz und Mischungen enthaltend hochschlagzähes Polystyrolharz, und
(b) ein Phosphoramid mit einem Glasübergangspunkt von wenigstens 20°C mit der Formel: 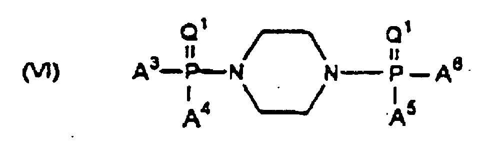 worin jedes Q¹ Sauerstoff ist und jeder Rest A ein 2,6-Dimethylphenoxyrest ist, und
(c) wenigstens eine polymere oder nicht-polymere Zusatz flammhemmende Verbindung ausgewählt aus der Gruppe bestehend aus Phosphatestern, Phosphonatestern, Phosphinatestern, Phosphinen, Phosphinoxiden, Resorcin, Bis(diphenylphosphat), Bisphenol A bis(diphenylphosphat), Triphenylphosphat und Tricresylphsophat.

## Revendications

1. Composition de résine comprenant les suivants et tous produits de réaction de ceux-ci :
a) une résine thermoplastique sélectionnée à partir du groupe constitué par : (i) des résines polycarbonates et des mélanges contenant au moins une résine polycarbonate, (ii) des résines d'éther de polyphénylène et des mélanges contenant au moins une résine d'éther de polyphénylène, (iii) une résine de polystyrène et des mélanges contenant de la résine de polystyrène, (iv) une résine copolymère contenant du styrène et des mélanges contenant de la résine copolymère contenant du styrène ; (v) une résine copolymère greffée contenant du styrène et des mélanges contenant de la résine copolymère greffée contenant du styrène ; et (vi) une résine polystyrène à forte résistance aux chocs et des mélanges contenant une résine polystyrène à forte résistance aux chocs, et
b) au moins un phosphoramide présentant un point de transition vitreuse d'au moins 0°C selon la formule : 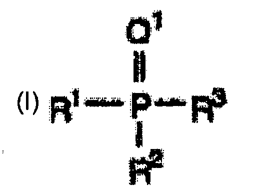 dans laquelle :
Q1 est de l'oxygène ou du soufre ;
R1 est un résidu amine ; et
R2 et R3 sont chacun, de manière indépendante, un alkyloxy, un alkylthio, un aryloxy ou un résidu arylthio ou un résidu aryloxy ou arylthio contenant au moins une substitution alkyle ; ou un résidu amine ; et
c) au moins un composé ignifuge additif comprenant au moins un élément polymère ou non polymère sélectionné à partir du groupe constitué par des esters de phosphate, des esters de thiophosphate, des esters de phosphonate, des esters de thiophosphonate, des esters de phosphinate, des esters de thiophosphinate, des phosphines, des oxydes de phosphine, des oxydes de thiophosphine et des sels de phosphonium.

2. Composition selon la revendication 1, dans laquelle au moins un phosphoramide présente un point de transition vitreuse d'au moins 10°C.

3. Composition selon la revendication 1, dans laquelle la totalité du phosphoramide du composant b) présente un point de transition vitreuse d'au moins 10°C.

4. Composition selon la revendication 1, dans laquelle au moins un phosphoramide présente un point de transition vitreuse d'au moins 20°C.

5. Composition selon la revendication 1, dans laquelle la totalité du phosphoramide du composant b) présente un point de transition vitreuse d'au moins 20°C.

6. Composition selon la revendication 1, dans laquelle la résine thermoplastique est sélectionnée à partir du groupe constitué par une résine polystyrène choc, un polystyrène syndiotactique, des mélanges éther de polyphénylène / résine polystyrène choc, des mélanges éther de polyphénylène /résine de polystyrène syndiotactique, des mélanges polycarbonate-SAN, des mélanges polycarbonate-ABS, des mélanges polycarbonate-SAN-ABS, et des mélanges polycarbonate-polyester.

7. Composition selon la revendication 1, dans laquelle la résine thermoplastique est au moins l'un de polycarbonates, d'éthers de polyphénylène, de polystyrènes choc, de polystyrènes syndiotactiques, de copolymères acrylonitrile-butadiène-styrène, et de copolymères styrène-acrylonitrile.

8. Composition selon la revendication 1, dans laquelle la résine thermoplastique comprend au moins un polycarbonate et de l'ABS.

9. Composition selon la revendication 8, dans laquelle le au moins un polycarbonate comprend du polycarbonate de bisphénol A et un copolycarbonate de bisphénol A et de 4,4'-(3,3,5-triméthylcycto-hexylidène) diphénol.

10. Composition selon la revendication 8, dans laquelle le au moins phosphoramide comprend un phosphoramide selon la formule VI : 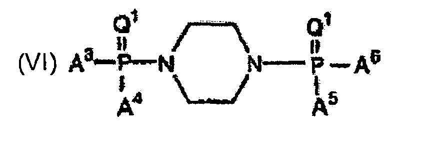 dans laquelle chaque Q1 est, de manière indépendante, de l'oxygène ou du soufre ; et chaque fraction A est une fraction 2,6-diméthylphénoxy ou une fraction 2,4,6-triméthylphénoxy.

11. Composition selon la revendication 8, dans laquelle le au moins phosphoramide comprend un phosphoramide selon la formule VI : 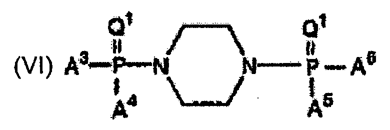 dans laquelle chaque Q1 est de l'oxygène ; et chaque fraction A est une fraction 2,6-diméthylphénoxy.

12. Composition selon la revendication 1, dans laquelle la résine thermoplastique comprend de l'éther de polyphénylène et une résine polystyrène choc.

13. Composition selon la revendication 1, dans laquelle le au moins un phosphoramide comprend un phosphoramide selon la formule VI : 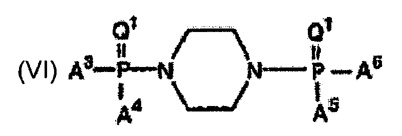 dans laquelle chaque Q1 est, de manière indépendante, de l'oxygène ou du soufre ; et chaque fraction A est une fraction 2,6-diméthylphénoxy ou une fraction 2,4,6-triméthylphénoxy.

14. Composition selon la revendication 1, dans laquelle le au moins un phosphoramide comprend un phosphoramide selon la formule VI : 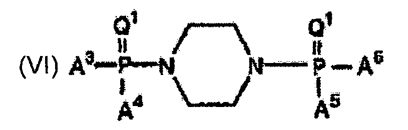 dans laquelle chaque Q1 est de l'oxygène ; et chaque fraction A est une fraction 2,6-diméthylphénoxy.

15. Composition selon la revendication 1, dans laquelle l'agent ignifuge additif comprend au moins un élément sélectionné à partir du groupe constitué par le bis(diphénylphosphate) de résorcine, le bis(diphénylphosphate) de bisphénol A, le triphénylphosphate et le tricrésylphosphate.

16. Composition selon la revendication 1, dans laquelle l'association de phosphoramide et d'agent ignifuge additif est présente en une quantité efficace afin de communiquer à la composition de résine un indice d'inflammabilité de V-0, V-1 ou V-2 selon le protocole UL-94 de Underwriter's Laboratory lorsqu'il est mesuré sur un spécimen d'essai de dimensions de 0,3175 cm (0,125 pouce) par 1,27 cm (0,5 pouce) par 12,7 cm (5 pouces).

17. Composition selon la revendication 1, dans laquelle le au moins un phosphoramide comprend un phosphoramide selon la formule VI : 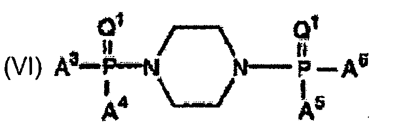 dans laquelle chaque Q1 est, de manière indépendante, de l'oxygène ou du soufre ; et chaque fraction A est une fraction 2,6-diméthylphénoxy ou une fraction 2,4,6-triméthylphénoxy.

18. Composition selon la revendication 1, dans laquelle au moins un phosphoramide comprend un phosphoramide selon la formule VI : 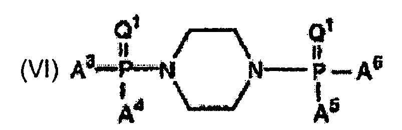 dans laquelle chaque Q1 est de l'oxygène ; et chaque fraction A est une fraction 2,6-diméthylphénoxy.

19. Composition selon la revendication 1, dans laquelle au moins un phosphoramide est présent en une quantité efficace afin de communiquer à la composition de résine un indice d'inflammabilité de V-0, V-1 ou V-2 selon le protocole UL-94 de Underwriter's Laboratory lorsqu'il est mesuré sur un spécimen d'essai de dimensions de 0,3175 cm (0,125 pouce) par 1,27 cm (0,5 pouce) par 12,7 cm (5 pouces).

20. Composition selon la revendication 1, dans laquelle la quantité totale de phosphore pour 100 parts de matières résineuses est comprise dans la plage de 0,008 à 3 parties en poids.

21. Composition selon la revendication 1, qui est sensiblement exempte de chlore et de brome.

22. Composition selon la revendication 1, dans laquelle R1 est selon la formule X : 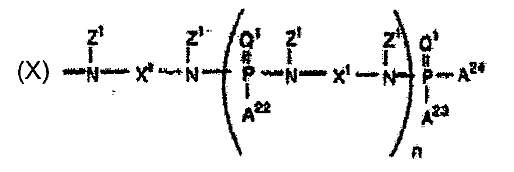 dans laquelle
chaque Q1 est, de manière indépendante, de l'oxygène ou du soufre ;
chacun de A22 à A24 est, de manière indépendante, un résidu alkyloxy, alkylthio, aryloxy, ou arylthio ou un résidu aryloxy ou arylthio contenant au moins une substitution alkyle ; ou un résidu amine ;
chaque Z1 est un radical alkyle, un radical aromatique, ou un radical aromatique contenant au moins une substitution alkyle ;
chaque X1 est un radical alkylidène, un radical aromatique, ou un radical aromatique contenant au moins une substitution alkyle ;
n est compris entre 0 et 5 ; et
R2 et R3 sont chacun, de manière indépendante, un résidu alkyloxy, alkylthio, aryloxy ou arylthio ou un résidu aryloxy ou arylthio contenant au moins une substitution alkyle ; ou un résidu amine.

23. Composition selon la revendication 1, dans laquelle R1 est selon la formule XI 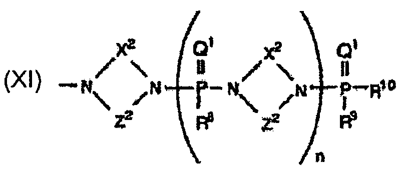 dans laquelle
chaque Q1 est, de manière indépendante, de l'oxygène ou du soufre ;
chaque X2 est un alkylidène, un aryle, ou un alkaryle ;
chaque Z2 est un alkylidène ;
chacun de R8, R9, et R10 est, de manière indépendante, un résidu alkyloxy, un résidu aryloxy, un résidu aryloxy contenant au moins une substitution alkyle, ou un résidu amine ; et
n est compris entre 0 et 5 ; et
R2 et R3 sont chacun, de manière indépendante, un résidu alkyloxy, alkylthio, aryloxy, ou arylthio, ou un résidu aryloxy ou arylthio contenant au moins une substitution alkyle ; ou un résidu amine.

24. Composition selon la revendication 1, dans laquelle le au moins un phosphoramide présentant un point de transition vitreuse d'au moins 0°C est selon la formule VIII : 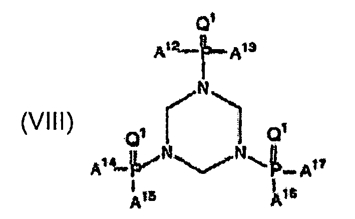 dans laquelle
chaque Q1 est, de manière indépendante, de l'oxygène ou du soufre ; et
chacun de A12 à A17 est, de manière indépendante, un résidu alkyloxy, alkylthio, aryloxy ou arylthio, ou un résidu aryloxy ou arylthio contenant au moins une substitution alkyle ; ou un résidu amine.

25. Composition selon la revendication 1, dans laquelle le au moins un phosphoramide cyclique présentant un point de transition vitreuse d'au moins 0°C est selon la formule XII : 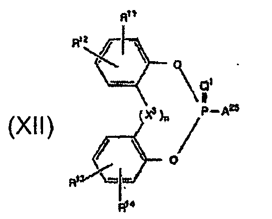 dans laquelle Q1 est de l'oxygène ou du soufre ;
chacun de R11 à R14 est, de manière indépendante, un hydrogène ou un radical alkyle ;
X3 est un radical alkylidène ;
n est soit 0 soit 1 ; et
A25 est un groupe dérivé d'une amine primaire ou secondaire présentant les mêmes radicaux ou des radicaux différents qui peuvent être aliphatiques, alicycliques, aromatiques ou alkaryles, ou A25 est un groupe dérivé d'une amine hétérocyclique, ou A25 est un composé hydrazine.

26. Composition selon la revendication 1, dans laquelle au moins un phosphoramide bis(cyclique) présentant un point de transition vitreuse d'au moins 0°C est selon la formule XIII : 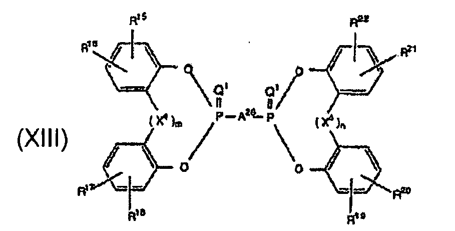 dans laquelle chaque Q1 est, de manière indépendante, de l'oxygène ou du soufre ;
chacun de R15 à R22 est, de manière indépendante, un hydrogène ou un radical alkyle ;
X4 est un radical alkylidène ; m et n sont chacun, de manière indépendante 0 ou 1 ; et
A26 est selon la formule 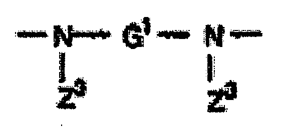
dans laquelle G1 est du soufre, un radical alkylidène, un radical aryle, ou un radical alkaryle ; et chaque Z3 est, de manière indépendante, un radical alkyle ou un radical aryle ; ou dans laquelle A26 est selon la formule 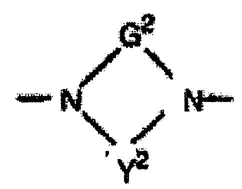 dans laquelle G2 est un alkylidène, un aryle, ou un alkaryle, et Y2 est un alkylidène.

27. Composition de résine constituée principalement par :
a) une résine thermoplastique sélectionnée à partir du groupe constitué par : (i) des résines polycarbonates et des mélanges contenant au moins une résine polycarbonate, (ii) des résines d'éther de polyphénylène et des mélanges contenant au moins une résine d'éther de polyphénylène, (iii) une résine de polystyrène et des mélanges contenant de la résine de polystyrène, (iv) une résine copolymère contenant du styrène et des mélanges contenant de la résine copolymère contenant du styrène ; (v) une résine copolymère greffée contenant du styrène et des mélanges contenant de la résine copolymère greffée contenant du styrène ; et (vi) une résine polystyrène à forte résistance aux chocs et des mélanges contenant une résine polystyrène à forte résistance aux chocs, et
b) au moins un phosphoramide présentant un point de transition vitreuse d'au moins 0°C selon la formule : 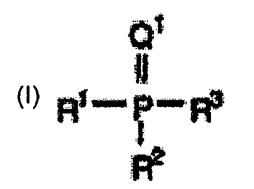 dans laquelle
Q1 est de l'oxygène ou du soufre ;
R1 est un résidu amine, et
R2 et R3 sont chacun, de manière indépendante, un résidu alkyloxy, alkylthio, aryloxy ou arylthio, ou un résidu aryloxy ou arylthio contenant au moins une substitution alkyle ; ou un résidu amine ; et
c) au moins un composé ignifuge additif selon la revendication 1.

28. Article réalisé à partir de la composition selon la revendication 1.

29. Article selon la revendication 28, qui forme un collier de déviation pour un tube à rayon cathodique, un collier de déviation pour une télévision, un collier de déviation du type à fente, un collier de déviation à bobine moulée, un panneau arrière de télévision, un poste de déchargement, un socle, une facette, une palette, un commutateur, un boîtier de commutateur, une prise, un boîtier de prise, un connecteur électrique, un dispositif de connexion, une embase, un boîtier de télévision, un boîtier d'ordinateur, un boîtier d'ordinateur de bureau, un boîtier d'ordinateur portable, un boîtier d'ordinateur portatif, un boîtier d'ordinateur de poche ; un boîtier d'écran de surveillance, un boîtier d'imprimante, un clavier, un boîtier de télécopieur, un boîtier de photocopieur, un boîtier de téléphone, un boîtier de téléphone mobile, un boîtier d'émetteur radio, un boîtier de récepteur radio, un appareil d'éclairage, un boîtier de chargeur de batterie, un boîtier de batterie, un composant électrique automobile, un boîtier d'antenne, un boîtier de transformateur, un modem, une cartouche, un boîtier de dispositif d'interface de réseau, un boîtier de circuit de coupure, un boîtier d'appareil de mesure, un panneau pour appareil humide ou sec, un panneau de lave-vaisselle, un panneau de lave-linge, un panneau de sèche-linge, un panneau de réfrigérateur ; une enceinte de chauffage ou de ventilation, un ventilateur, un boîtier de conditionneur d'air, un revêtement ou siège pour transport public ; un revêtement ou siège pour train, métro ou bus.

30. Procédé d'augmentation de la température de déformation à chaud d'une composition ignifuge contenant une certaine quantité d'au moins un phosphoramide et au moins un agent ignifuge additif efficace afin de communiquer à la composition un indice d'inflammabilité au moins égal à V-2 selon le protocole UL-94 de Underwriter's Laboratory lorsqu'il est mesuré sur un spécimen d'essai de dimensions de 0,3175 cm (0,125 pouce) par 1,27 cm (0,5 pouce) par 12,7 cm (5 pouces), dans lequel le procédé comprend l'association d'au moins une résine thermoplastique, au moins un phosphoramide présentant un point de transition vitreuse d'au moins 0°C et au moins un agent ignifuge additif, dans lequel la résine thermoplastique, le phosphoramide et l'agent ignifuge additif sont selon la revendication 1.

31. Procédé selon la revendication 30, dans lequel la composition présente un indice d'inflammabilité au moins égal à V-1.

32. Procédé selon la revendication 30, dans lequel la composition présente un indice d'inflammabilité au moins égal à V-0.

33. Procédé selon la revendication 30, dans lequel au moins un phosphoramide présente un point de transition vitreuse d'au moins 10°C.

34. Procédé selon la revendication 30, dans lequel le phosphoramide présente un point de transition vitreuse d'au moins 10°C.

35. Procédé selon la revendication 33, dans lequel au moins un phosphoramide présente un point de transition vitreuse d'au moins 20°C.

36. Procédé selon la revendication 30, dans lequel le phosphoramide présente un point de transition vitreuse d'au moins 20°C.

37. Procédé selon la revendication 30, dans lequel le au moins un phosphoramide comprend un phosphoramide selon la formule VI : 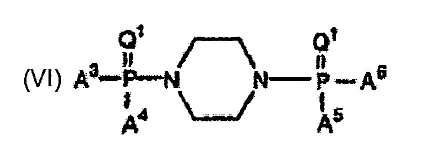 dans laquelle chaque Q1 est, de manière indépendante, de l'oxygène ou du soufre ; et chaque fraction A est une fraction 2,6-diméthylphénoxy ou une fraction 2,4,6-triméthylphénoxy.

38. Procédé selon la revendication 30, dans lequel la résine thermoplastique est une résine polycarbonate ou un mélange contenant au moins une résine polycarbonate.

39. Procédé selon la revendication 30, dans lequel la résine thermoplastique comprend au moins un polycarbonate et de l'ABS.

40. Procédé selon la revendication 39, dans lequel le au moins un polycarbonate comprend du polycarbonate de bisphénol A et un copolycarbonate de bisphénol A et de 4,4'-(3,3,5-triméthylcyclo-hexylidène) diphénol.

41. Procédé selon la revendication 30, dans lequel l'agent ignifuge additif comprend au moins un élément sélectionné à partir du groupe constitué par le bis(diphénylphosphate) de résorcinol, le bis(diphénylphosphate) de bisphénol A, le triphénylphosphate et le tricrésylphosphate.

42. Procédé selon la revendication 30, dans lequel la composition est sensiblement exempte de chlore et de brome.

43. Composition ignifuge selon la revendication 42.

44. Composition ignifuge selon la revendication 30.

45. Composition de résine comprenant les éléments suivants et tous produits de réaction de ceux-ci :
(a) au moins une résine thermoplastique sélectionnée à partir du groupe constitué par : (i) des résines polycarbonates et des mélanges contenant au moins une résine polycarbonate, (ii) des résines d'éther de polyphénylène et des mélanges contenant au moins une résine d'éther de polyphénylène, (iii) une résine polystyrène et des mélanges contenant de la résine de polystyrène, (iv) une résine copolymère contenant du styrène et des mélanges contenant de la résine copolymère contenant du styrène ; (v) une résine copolymère greffée contenant du styrène et des mélanges contenant de la résine copolymère greffée contenant du styrène, et (vi) une résine polystyrène choc et des mélanges contenant de la résine polystyrène choc, et
(b) un phosphoramide présentant un point de transition vitreuse d'au moins 20°C selon la formule VI : 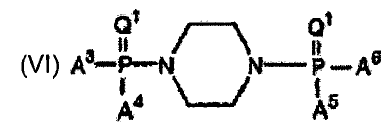 dans laquelle chaque Q1 est de l'oxygène ; et chaque fraction A est une fraction 2,6-diméthylphénoxy, et
(c) au moins un composé ignifuge additif polymère ou non polymère sélectionné à partir du groupe constitué par des esters de phosphate, des sels de phosphate, des esters de phosphonate, des sels de phosphonate, des esters de phosphinate, des sels de phosphinate, des phosphines, des sels de phosphonium, des oxydes de phosphine, des sels de pyrophosphate, des sels de métaphosphate, le bis(diphénylphosphate) de résorcine, le bis(diphénylphosphate) de bisphénol A, le triphénylphosphate et le tricrésylphosphate.

46. Procédé d'augmentation de la température de déformation à chaud d'un composé ignifuge contenant une certaine quantité d'au moins un phosphoramide et au moins un agent ignifuge additif efficace afin de communiquer à la composition un indice d'inflammabilité au moins égal à V-2 selon le protocole UL-94 de Underwriter's Laboratory lorsqu'il est mesuré sur un spécimen d'essai de dimensions de 0,3175 cm (0,125 pouce) par 1,27 cm (0,5 pouce) par 12,7 cm (5 pouces), dans lequel le procédé comprend le mélange
(a) d'au moins une résine thermoplastique sélectionnée à partir du groupe constitué par des (i) des résines polycarbonates et des mélanges contenant au moins une résine polycarbonate, (ii) des résines d'éther de polyphénylène et des mélanges contenant au moins une résine d'éther de polyphénylène, (iii) une résine polystyrène et des mélanges contenant de la résine de polystyrène, (iv) une résine copolymère contenant du styrène et des mélanges contenant de la résine copolymère contenant du styrène ; (v) une résine copolymère greffée contenant du styrène et des mélanges contenant de la résine copolymère greffée contenant du styrène, et (vi) une résine polystyrène choc et des mélanges contenant une résine polystyrène choc, et
(b) d'un phosphoramide présentant un point de transition vitreuse d'au moins 20°C selon la formule VI : 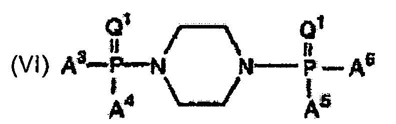 dans laquelle chaque Q1 est de l'oxygène ; et chaque fraction A est une fraction 2,6-diméthylphénoxy, et
(c) d'au moins un composé ignifuge additif polymère ou non polymère sélectionné à partir du groupe constitué par des esters de phosphate, des esters de phosphonate, des esters de phosphinate, des phosphines, des oxydes de phosphine, le bis(diphénylphosphate) de résorcinol, le bis(diphénylphosphate) de bisphénol A, le triphénylphosphate et le tricrésylphosphate.
